(19) Europäisches Patentamt
European Patent Office
Office européen des brevets

(11) **EP 4 557 374 A1**

(12) **EUROPEAN PATENT APPLICATION**
published in accordance with Art. 153(4) EPC

(43) Date of publication:
**21.05.2025 Bulletin 2025/21**

(21) Application number: **24744198.3**

(22) Date of filing: **15.01.2024**

(51) International Patent Classification (IPC):
*H01L 27/15* *(2006.01)*

(52) Cooperative Patent Classification (CPC):
**H10H 20/841; H10H 29/10**

(86) International application number:
**PCT/CN2024/072270**

(87) International publication number:
**WO 2024/153022 (25.07.2024 Gazette 2024/30)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **20.01.2023 CN 202310090546**

(71) Applicant: **Huawei Technologies Co., Ltd.**
**Shenzhen, Guangdong 518129 (CN)**

(72) Inventors:
• WANG, Lei
  Shenzhen, Guangdong 518129 (CN)
• ZHANG, Li
  Shenzhen, Guangdong 518129 (CN)
• JIANG, Fulong
  Shenzhen, Guangdong 518129 (CN)
• CHEN, Shunlin
  Shenzhen, Guangdong 518129 (CN)

(74) Representative: **Pfenning, Meinig & Partner mbB**
**Patent- und Rechtsanwälte**
**Theresienhöhe 11a**
**80339 München (DE)**

(54) **DISPLAY PANEL AND ELECTRONIC DEVICE**

(57)     This application provides a display panel and an electronic device. The display panel includes a display area, and the display area includes a driver substrate, a pixel structure, a first reflection layer, a first reflection grating, and a second reflection layer. The driver substrate, the first reflection layer, and the pixel structure are sequentially disposed. The driver substrate is configured to enable the pixel structure to emit light, and the second reflection layer is connected to a side surface of the pixel structure. The first reflection grating and the first reflection layer form a resonant cavity, and the resonant cavity is configured to enable light with a specific wavelength emitted by the pixel structure to resonate. The resonant cavity may generate resonance for a light ray in a normal direction and a nearby light ray, and a light ray with a large deviation angle from the normal direction is weakened. Therefore, the resonant cavity may improve light emitting intensity in the normal direction of the display panel, and reduce a light emitting angle of the display panel. The second reflection layer may reflect a light ray emitted by the pixel structure from the side surface, to avoid optical crosstalk between adjacent pixel structures.

FIG. 3

## Description

This application claims priority to Chinese Patent Application No. 202310090546.X, filed with the China National Intellectual Property Administration on January 20, 2023, and entitled "DISPLAY PANEL AND ELECTRONIC DEVICE", which is incorporated herein by reference in its entirety.

## TECHNICAL FIELD

This application relates to the field of display device technologies, and in particular, to a display panel and an electronic device.

## BACKGROUND

A micro-light emitting diode (Micro-Light Emitting Diode, Micro-LED) display panel is used to array and miniaturize a conventional LED, to form an ultra-small pixel, thereby achieving a high pixel. However, after a size of a pixel structure is reduced, when the display panel displays a frame of picture, a proportion of light rays emitted from a side surface of pixels that are emitting light to light rays emitted by the entire pixel structure gradually increases. Consequently, light emitted in a forward direction of the display panel is reduced, and light emitting efficiency is reduced. For an AR display application, distribution of light emitting angles of a micro-LED needs to be as concentrated as possible, so that as much light as possible can be coupled by a waveguide for near-eye display. However, a light emitting angle of a conventional micro-LED component structure is similar to that of Lambertian light emitting, and a proportion of light emitted within a small light angle range is not high. Consequently, brightness of final AR display is limited, and efficiency is low.

## SUMMARY

This application provides a display panel and an electronic device, to reduce a light emitting angle of the display panel to a great extent, and improve, to a great extent, light emitting intensity in a direction perpendicular to a light emitting surface of the display panel.

According to a first aspect, an embodiment of this application provides a display panel. The display panel includes a display area. The display area includes a driver substrate, a pixel structure, a first reflection layer, a first reflection grating, and a second reflection layer. The driver substrate, the first reflection layer, and the pixel structure are sequentially disposed. The driver substrate is configured to enable the pixel structure to emit light, and the second reflection layer is connected to a side surface of the pixel structure.

The first reflection grating and the first reflection layer form a resonant cavity, and the resonant cavity is configured to enable light with a specific wavelength emitted by the pixel structure to resonate.

It may be understood that this application merely provides the first reflection grating and the first reflection layer of the resonant cavity by using an example. A side wall of the resonant cavity may be formed by another component of the display panel, for example, the second reflection layer. Specifically, this is not limited in this application.

It may be understood that, on the display panel in this application, the first reflection layer and the first reflection grating are disposed in the display area, and the first reflection layer and the first reflection grating may form the resonant cavity, so that the light (namely, a target light ray) with a specific wavelength emitted by the pixel structure can resonate back and forth between the first reflection layer and the first reflection grating, to generate resonance enhancement. Light emitting intensity in a direction (namely, a normal direction) perpendicular to a light emitting surface of the display panel may be improved to a great extent. The normal direction is the direction perpendicular to the light emitting surface of the display panel.

A vertical cavity length L of the resonant cavity, and thicknesses and materials of the first reflection grating and the first reflection layer may be selected based on the wavelength of the target light ray, so that the formed resonant cavity performs resonance enhancement for the target light ray with a specific wavelength. A light ray with another wavelength is not enhanced, and the first reflection grating causes partial blocking. The enhanced target light ray is finally emitted from the display panel, and is received by a user, so that the resonant cavity can improve light emitting efficiency of the display panel and reduce a half-peak width of a light emitting spectrum of the light ray emitted by the pixel structure.

In addition, the resonant cavity formed by the first reflection layer and the first reflection grating may generate resonance for a light ray in the normal direction and a nearby light ray. Therefore, the resonant cavity enhances light emitted in the normal direction of the display panel, and a light ray with a large deviation angle from the normal direction is weakened. Therefore, the resonant cavity may further reduce a light emitting angle of the display panel to a great extent.

The second reflection layer is connected to the side surface of the pixel structure, and can reflect a light ray emitted by the pixel structure from the side surface, to avoid a problem of optical crosstalk between two adjacent pixel structures. To be specific, a light ray emitted by one of the pixel structures from a side surface is not easily propagated to the other pixel structure. Particularly, when the display panel displays a frame of picture, if one of the two adjacent pixel structures needs to emit light and the other does not emit light, crosstalk of a light ray of the pixel structure that emits light to the pixel structure that does not emit light does not easily occur. The second reflection layer reflects the light ray emitted by the pixel structure from the side surface, so that most of the light ray emitted by the pixel structure from the side surface can be reflected back to the pixel structure by the second reflection layer, and then is emitted from a top surface of the pixel structure and received by the user, to improve light emitting intensity of a front surface of the display panel.

In a possible implementation, the first reflection grating is disposed on a side that is of the pixel structure and that is away from the first reflection layer.

It may be understood that, the pixel structure is located between the first reflection layer and the first reflection grating, and the first reflection grating may be configured to reflect a light ray emitted by the pixel structure from a top surface, so that the light ray can resonate in the resonant cavity formed by the first reflection layer and the first reflection grating.

In a possible implementation, the pixel structure includes a first semiconductor layer, a light emitting layer, and a second semiconductor layer. The light emitting layer is located between the first semiconductor layer and the second semiconductor layer. The resonant cavity is configured to enable light with a specific wavelength emitted by the light emitting layer to resonate. The first reflection layer is disposed between the driver substrate and the first semiconductor layer. The first reflection grating is disposed in the second semiconductor layer. The second reflection layer is connected to a side surface of the light emitting layer.

It may be understood that, a material of the first reflection grating may correspond to a material doping type of the second semiconductor layer, and n-type or p-type doping is performed, to implement conductivity. The first reflection grating is directly formed in a process of forming the second semiconductor layer, so that a technological process can be reduced, and costs can be reduced.

In a possible implementation, in a direction of the first reflection layer toward the first reflection grating, a vertical cavity length of the resonant cavity is within a range of 0.5 micrometers to 4 micrometers. The vertical cavity length L is a distance between the first reflection grating and the first reflection layer in a thickness direction of the display panel.

It may be understood that the vertical cavity length L is set, so that resonance enhancement can be generated for a target light ray with a specific wavelength, to enhance light emitted in a normal direction of the display panel. After resonance enhancement is performed on the target light ray in the resonant cavity, a part of the target light ray may be emitted from a top surface of the pixel structure, pass through the first reflection grating, finally become an output light ray of the display panel, and be received by a user.

In a possible implementation, the first reflection grating is a Distributed Bragg Reflector, the first reflection grating includes at least one first grating unit, and the first grating unit includes a first reflection sub-grating and a second reflection sub-grating that are stacked.

A refractive index of the first reflection sub-grating of the first grating unit is within a range of 1 to 5.

A refractive index of the second reflection sub-grating of the first grating unit is within the range of 1 to 5.

A difference between the refractive index of the first reflection sub-grating of the first grating unit and the refractive index of the second reflection sub-grating of the first grating unit is M, and M meets: M≥0.2.

It may be understood that the refractive index of the first reflection sub-grating may be greater than the refractive index of the second reflection sub-grating, or the refractive index of the first reflection sub-grating may be less than the refractive index of the second reflection sub-grating. A larger difference M between the refractive index of the first reflection sub-grating of the first grating unit and the refractive index of the second reflection sub-grating indicates a better reflection effect of the first reflection grating on a target light ray.

In a possible implementation, the display panel further includes a first conductive layer, and the first conductive layer is connected between the first reflection layer and the pixel structure.

It may be understood that the first conductive layer may be configured to form a good ohmic contact between the first semiconductor layer and the first reflection layer, to reduce contact resistance.

In a possible implementation, the display panel further includes a second conductive layer, and the second conductive layer is connected between the first reflection grating and the pixel structure.

It may be understood that when the driver substrate applies a current to the pixel structure, the second conductive layer may assist in diffusing the current, so that the current is more quickly diffused to the pixel structure of the entire display panel, and light emitting uniformity of the display panel is improved.

In a possible implementation, the display panel further includes a passivation layer, the passivation layer is connected between the side surface of the pixel structure and the second reflection layer, and the passivation layer is configured to insulate the pixel structure from the second reflection layer.

It may be understood that the passivation layer is disposed between the side surface of the pixel structure and the second reflection layer, so that the side surface of the pixel structure is not electrically connected to the second reflection layer made of a metal material, and a risk of electric leakage on the side surface of the pixel structure is reduced.

In a possible implementation, the first reflection grating is arc-shaped.

It may be understood that the arc-shaped first reflection grating may reflect light in a normal direction emitted from a top surface of the pixel structure, and the reflected light can still be in the normal direction, and can be reflected by the first reflection layer again, to form resonance. Light that deviates from the normal direction is converged to the normal direction by the arc-shaped first reflection grating within a specific range, to increase a proportion of light in the normal direction, so that resonance enhancement can be performed on more light rays in the resonant cavity, and light emitting efficiency of the display panel can be improved.

In a possible implementation, the first reflection layer is a Distributed Bragg Reflector, the first reflection layer includes at least one first reflection unit, the first reflection unit includes a first reflection sub-layer and a second reflection sub-layer that are stacked, a material of the first reflection sub-layer is silicon dioxide, and a material of the second reflection sub-layer is titanium dioxide.

It may be understood that, materials and corresponding thicknesses of the first reflection sub-layer and the second reflection sub-layer that are included in the first reflection unit are designed based on a wavelength of a target light ray that needs to be reflected, to selectively implement reflection of the target light ray with a specific wavelength. The first reflection grating cooperates with the first reflection layer to form the resonant cavity, so that light (namely, the target light ray) with a specific wavelength emitted by the pixel structure can resonate back and forth between the first reflection layer and the first reflection grating.

In a possible implementation, the first reflection layer is provided with a first through hole, the display panel further includes a first electrode, the first electrode is disposed in the first through hole, one end of the first electrode is electrically connected to the driver substrate, and the other end is electrically connected to the pixel structure.

It may be understood that when the first reflection layer is a Distributed Bragg Reflector, a material of the first reflection layer is a dielectric material. Therefore, the first reflection layer is provided with the first through hole. One end of the first electrode may be connected to the driver substrate, and the other end may pass through the first through hole and be electrically connected to the pixel structure, so that an electrical signal of the driver substrate can be quickly transmitted to the pixel structure by using the first electrode.

In a possible implementation, the display panel further includes a second reflection grating, and the second reflection grating is located in the semiconductor layer of the pixel structure.

It may be understood that, compared with a solution in which a display panel includes a first reflection layer or a second reflection grating, in this solution, the display panel includes the first reflection layer and the second reflection grating, and the first reflection layer and the second reflection grating may separately form a resonant cavity with the first reflection grating, so that a light ray emitted by the pixel structure from a bottom surface can be reflected as much as possible, to improve light emitting efficiency of the display panel.

The second reflection grating is located in the semiconductor layer of the pixel structure, and the second reflection grating is directly formed in a process of forming an epitaxial backplane, so that a technological process can be reduced, and costs can be reduced.

In a possible implementation, a height of the pixel structure in a thickness direction of the display panel is within a range of 100 nanometers to 10 micrometers. A width of the pixel structure in a direction parallel to the display panel is within a range of 100 nanometers to 1 millimeter.

It may be understood that a size of the pixel structure is small, and a large quantity of pixel structures may be disposed in the limited display area. This helps improve pixel density of the display panel. Imaging quality of the display panel is good. This helps a user see a clear image.

In a possible implementation, a light emitting angle of the display panel is less than 40°.

It may be understood that the light emitting angle of the display panel is within a small range, and light emitting efficiency is high. When the display panel is used in augmented reality (augmented reality, AR) glasses, virtual reality (virtual reality, VR) glasses, a head-up display (head-up display, HUD) device, or the like, the display panel may be better coupled to an optical waveguide structure or have a better projection effect.

In a possible implementation, a light emitting angle of the display panel is less than 60°.

In a possible implementation, a light emitting angle of the display panel is less than 90°.

In a possible implementation, a spectral half-peak width of a light ray emitted by the display panel is within a range of 5 nanometers to 100 nanometers.

It may be understood that the spectral half-peak width of the light ray emitted by the display panel is small, and color rendering performance of the display panel is good.

According to a second aspect, an embodiment of this application provides a display panel. The display panel includes a display area, and the display area includes a driver substrate, a pixel structure, a first reflection grating, a first reflection layer, and a second reflection layer.

The driver substrate, the pixel structure, and the first reflection grating are sequentially disposed, and the second reflection layer is connected to a side surface of the pixel structure.

The pixel structure includes a first semiconductor layer, a light emitting layer, and a second semiconductor layer, the light emitting layer is located between the first semiconductor layer and the second semiconductor layer, the first reflection layer is disposed in the first semiconductor layer, the first reflection layer and the first reflection grating form a resonant cavity, and the resonant cavity is configured to enable light with a specific wavelength emitted by the light emitting layer to resonate.

It may be understood that this application merely provides the first reflection grating and the first reflection layer of the resonant cavity by using an example. A side wall of the resonant cavity may be formed by another component of the display panel, for example, the second reflection layer. Specifically, this is not limited in this application.

It may be understood that, on the display panel in this application, the first reflection layer and the first reflection grating are disposed in the display area, and the first reflection layer and the first reflection grating may form the resonant cavity, so that the light (namely, a target light ray) with a specific wavelength emitted by the pixel structure can resonate back and forth between the first reflection layer and the first reflection grating, to generate resonance enhancement. Light emitting intensity in a direction (namely, a normal direction) perpendicular to a light emitting surface of the display panel may be improved to a great extent. The normal direction is the direction perpendicular to the light emitting surface of the display panel.

A vertical cavity length L of the resonant cavity, and thicknesses and materials of the first reflection grating and the first reflection layer may be selected based on the wavelength of the target light ray, so that the formed resonant cavity performs resonance enhancement for the target light ray with a specific wavelength. A light ray with another wavelength is not enhanced, and the first reflection grating causes partial blocking. The enhanced target light ray is finally emitted from the display panel, and is received by a user, so that the resonant cavity can improve light emitting efficiency of the display panel and reduce a half-peak width of a light emitting spectrum of the light ray emitted by the pixel structure.

In addition, the resonant cavity formed by the first reflection layer and the first reflection grating may generate resonance for a light ray in the normal direction and a nearby light ray. Therefore, the resonant cavity enhances light emitted in the normal direction of the display panel, and a light ray with a large deviation angle from the normal direction is weakened. Therefore, the resonant cavity may further reduce a light emitting angle of the display panel to a great extent.

The second reflection layer is connected to the side surface of the pixel structure, and can reflect a light ray emitted by the pixel structure from the side surface, to avoid a problem of optical crosstalk between two adjacent pixel structures. To be specific, a light ray emitted by one of the pixel structures from a side surface is not easily propagated to the other pixel structure. Particularly, when the display panel displays a frame of picture, if one of the two adjacent pixel structures needs to emit light and the other does not emit light, crosstalk of a light ray of the pixel structure that emits light to the pixel structure that does not emit light does not easily occur. The second reflection layer reflects the light ray emitted by the pixel structure from the side surface, so that most of the light ray emitted by the pixel structure from the side surface can be reflected back to the pixel structure by the second reflection layer, and then is emitted from a top surface of the pixel structure and received by the user, to improve light emitting intensity of a front surface of the display panel.

The first reflection layer is disposed in the first semiconductor layer, a material of the first reflection layer may correspond to a material doping type of the first semiconductor layer, and n-type or p-type doping is performed, to implement conductivity. The first reflection layer is directly formed in a process of forming the first semiconductor layer, so that a technological process can be reduced, and costs can be reduced.

In a possible implementation, in a direction of the first reflection layer toward the first reflection grating, a vertical cavity length of the resonant cavity is within a range of 0.5 micrometers to 4 micrometers.

It may be understood that the vertical cavity length L is set, so that resonance enhancement can be generated for a target light ray with a specific wavelength, to enhance light emitted in a normal direction of the display panel. After resonance enhancement is performed on the target light ray in the resonant cavity, a part of the target light ray may pass through the first reflection grating, emitted from a top surface of the pixel structure, finally become an output light ray of the display panel, and be received by a user.

In a possible implementation, the first reflection grating is a Distributed Bragg Reflector, the first reflection grating includes at least one first grating unit, and the first grating unit includes a first reflection sub-grating and a second reflection sub-grating that are stacked.

A refractive index of the first reflection sub-grating of the first grating unit is within a range of 1 to 5.

A refractive index of the second reflection sub-grating of the first grating unit is within the range of 1 to 5.

A difference between the refractive index of the first reflection sub-grating of the first grating unit and the refractive index of the second reflection sub-grating of the first grating unit is M, and M meets: $M \geq 0.2$.

It may be understood that a larger difference M between the refractive index of the first reflection sub-grating of the first grating unit and the refractive index of the second reflection sub-grating indicates a better reflection effect of the first reflection grating on a target light ray.

In a possible implementation, the display panel further includes a passivation layer, the passivation layer is connected between the side surface of the pixel structure and the second reflection layer, and the passivation layer is configured to insulate the pixel structure from the second reflection layer.

It may be understood that the passivation layer is disposed between the side surface of the pixel structure and the second reflection layer, so that the side surface of the pixel structure is not electrically connected to the second reflection layer made of a metal material, and a risk of electric leakage on the side surface of the pixel structure is reduced.

According to a third aspect, an embodiment of this application provides a display panel. The display panel includes a display area, and the display area includes a driver substrate, a pixel structure, a first reflection layer, a first reflection grating, and a second reflection layer.

The pixel structure is disposed on the driver substrate, the driver substrate is configured to enable the pixel structure to emit light, and the second reflection layer is connected to a side surface of the pixel structure.

The pixel structure includes a first semiconductor layer, a light emitting layer, and a second semiconductor layer, the light emitting layer is located between the first semiconductor layer and the second semiconductor layer, the first reflection layer is disposed in the first semiconductor layer, the first reflection grating is disposed in the second semiconductor layer, the first reflection grating and the first reflection layer form a resonant cavity, and the resonant cavity is configured to enable light with a specific wavelength emitted by the light emitting layer to resonate.

It may be understood that this application merely provides the first reflection grating and the first reflection layer of the resonant cavity by using an example. A side wall of the resonant cavity may be formed by another component of the display panel, for example, the second reflection layer. Specifically, this is not limited in this application.

It may be understood that, on the display panel in this application, the first reflection layer and the first reflection grating are disposed in the display area, and the first reflection layer and the first reflection grating may form the resonant cavity, so that the light (namely, a target light ray) with a specific wavelength emitted by the pixel structure can resonate back and forth between the first reflection layer and the first reflection grating, to generate resonance enhancement. Light emitting intensity in a direction (namely, a normal direction) perpendicular to a light emitting surface of the display panel may be improved to a great extent. The normal direction is the direction perpendicular to the light emitting surface of the display panel.

A vertical cavity length L of the resonant cavity, and thicknesses and materials of the first reflection grating and the first reflection layer may be selected based on the wavelength of the target light ray, so that the formed resonant cavity performs resonance enhancement for the target light ray with a specific wavelength. A light ray with another wavelength is not enhanced, and the first reflection grating causes partial blocking. The enhanced target light ray is finally emitted from the display panel, and is received by a user, so that the resonant cavity can improve light emitting efficiency of the display panel and reduce a half-peak width of a light emitting spectrum of the light ray emitted by the pixel structure.

In addition, the resonant cavity formed by the first reflection layer and the first reflection grating may generate resonance for a light ray in the normal direction and a nearby light ray. Therefore, the resonant cavity enhances light emitted in the normal direction of the display panel, and a light ray with a large deviation angle from the normal direction is weakened. Therefore, the resonant cavity may further reduce a light emitting angle of the display panel to a great extent.

The second reflection layer is connected to the side surface of the pixel structure, and can reflect a light ray emitted by the pixel structure from the side surface, to avoid a problem of optical crosstalk between two adjacent pixel structures. To be specific, a light ray emitted by one of the pixel structures from a side surface is not easily propagated to the other pixel structure. Particularly, when the display panel displays a frame of picture, if one of the two adjacent pixel structures needs to emit light and the other does not emit light, crosstalk of a light ray of the pixel structure that emits light to the pixel structure that does not emit light does not easily occur. The second reflection layer reflects the light ray emitted by the pixel structure from the side surface, so that most of the light ray emitted by the pixel structure from the side surface can be reflected back to the pixel structure by the second reflection layer, and then is emitted from a top surface of the pixel structure and received by the user, to improve light emitting intensity of a front surface of the display panel.

The first reflection layer is disposed in the first semiconductor layer, and the first reflection grating is disposed in the second semiconductor layer. A material of the first reflection layer may correspond to a material doping type of the first semiconductor layer, and n-type or p-type doping is performed, to implement conductivity. A material of the first reflection grating may correspond to a material doping type of the second semiconductor layer, and n-type or p-type doping is performed, to implement conductivity. The first reflection layer is directly formed in a process of forming the first semiconductor layer, and the first reflection grating is directly formed in a process of forming the second semiconductor layer, so that a technological process can be further reduced, and costs can be reduced.

In a possible implementation, in a direction of the first reflection layer toward the first reflection grating, a vertical cavity length of the resonant cavity is within a range of 0.5 micrometers to 4 micrometers.

It may be understood that the vertical cavity length L is set, so that resonance enhancement can be generated for a target light ray with a specific wavelength, to enhance light emitted in a normal direction of the display panel. After resonance enhancement is performed on the target light ray in the resonant cavity, a part of the target light ray may be emitted from a top surface of the pixel structure, pass through the first reflection grating, finally become an output light ray of the display panel, and be received by a user.

In a possible implementation, the first reflection grating is a Distributed Bragg Reflector, the first reflection grating includes at least one first grating unit, and the first grating unit includes a first reflection sub-grating and a second reflection sub-grating that are stacked.

A refractive index of the first reflection sub-grating of the first grating unit is within a range of 1 to 5.

A refractive index of the second reflection sub-grating of the first grating unit is within the range of 1 to 5.

A difference between the refractive index of the first reflection sub-grating of the first grating unit and the refractive index of the second reflection sub-grating of the first grating unit is M, and M meets: M≥0.2.

It may be understood that a larger difference M between the refractive index of the first reflection sub-grating of the first grating unit and the refractive index of the second reflection sub-grating indicates a better reflection effect of the first reflection grating on a target light ray.

According to a fourth aspect, an embodiment of this application provides an electronic device. The electronic device includes a bearing member and a display panel. The bearing member is configured to bear the display panel.

It may be understood that, the display panel is mounted on the bearing member, a light emitting angle of the display panel is small, light emitting intensity in a normal direction is high, and light emitting efficiency is good. In addition, optical crosstalk is not easily generated between adjacent pixel structures, so that user experience in using the electronic device is good.

**BRIEF DESCRIPTION OF DRAWINGS**

To describe technical solutions in embodiments of this application, the following describes the accompanying drawings used in embodiments of this application.

FIG. 1 is a diagram of a structure of an implementation of an electronic device according to an embodiment of this application;

FIG. 2 is a diagram of a structure of an implementation of a display panel shown in FIG. 1;

FIG. 3 is a partial sectional view of an implementation of the display panel shown in FIG. 2 at a line A-A;

FIG. 4 to FIG. 8 are partial sectional views of some corresponding preparation steps in a preparation method of a display panel;

FIG. 9 is a partial sectional view of an implementation of the display panel shown in FIG. 3;

FIG. 10 is a diagram of a structure of another implementation of the display panel shown in FIG. 3;

FIG. 11 is a diagram of a structure of still another implementation of the display panel shown in FIG. 3;

FIG. 12 is a diagram of a structure of another implementation of the display panel shown in FIG. 2;

FIG. 13 is a diagram of a structure of still another implementation of the display panel shown in FIG. 2;

FIG. 14 is a diagram of a structure of still another implementation of the display panel shown in FIG. 2;

FIG. 15 is a partial sectional view of another implementation of the display panel shown in FIG. 2 at A-A;

FIG. 16 is a partial sectional view of still another implementation of the display panel shown in FIG. 2 at A-A;

FIG. 17a is a partial sectional view of yet another implementation of the display panel shown in FIG. 2 at A-A;

FIG. 17b is a partial sectional view of yet another implementation of the display panel shown in FIG. 2 at A-A;

FIG. 17c is a partial sectional view of yet another implementation of the display panel shown in FIG. 2 at A-A;

FIG. 18 is a partial sectional view of yet another implementation of the display panel shown in FIG. 2 at A-A;

FIG. 19 is a partial sectional view of yet another implementation of the display panel shown in FIG. 2 at A-A;

FIG. 20 is a partial sectional view of yet another implementation of the display panel shown in FIG. 2 at A-A;

FIG. 21 is a partial sectional view of yet another implementation of the display panel shown in FIG. 2 at A-A;

FIG. 22 is a partial sectional view of yet another implementation of the display panel shown in FIG. 2 at A-A;

FIG. 23 is a partial sectional view of yet another implementation of the display panel shown in FIG. 2 at A-A;

FIG. 24 is a partial sectional view of yet another implementation of the display panel shown in FIG. 2 at A-A;

FIG. 25 is a partial sectional view of yet another implementation of the display panel shown in FIG. 2 at A-A; and

FIG. 26 is a diagram of a structure of an implementation of an electronic device according to an embodiment of this application.

**DESCRIPTION OF EMBODIMENTS**

In descriptions of embodiments of this application, it should be noted that, unless otherwise specified or limited expressly, the term "connection" should be understood in a broad sense. For example, the term "connection" may be a detachable connection or a nondetachable connection, or may be a direct connection or an indirect connection by using an intermediate medium. Direction terms mentioned in embodiments of this application, for example, "top", "bottom", "upper", and "lower" are directions with reference to the accompanying drawings. Therefore, the direction term is used to better and more clearly describe and understand embodiments of this application, and is not used to indicate or imply that an indicated apparatus or element needs to have a specific direction or be constructed and operated in a specific direction. Therefore, the direction term cannot be understood as a limitation on embodiments of this application. In the following descriptions, terms such as "first" and "second" are used only for description purposes, and cannot be understood as implying or implying relative importance or implicitly indicating a quantity of indicated technical features. Therefore, a feature limited by "first" or "second" may explicitly or implicitly include one or more features. In addition, "a plurality of" means "at least two".

The following describes embodiments of this application with reference to the accompanying drawings in embodiments of this application.

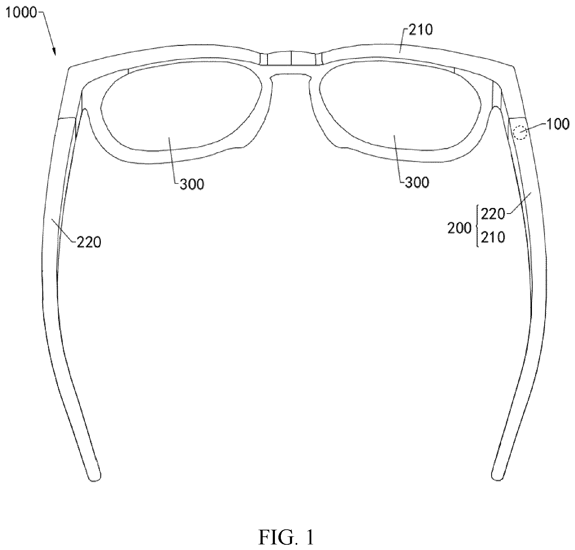

FIG. 1 is a diagram of a structure of an implementation of an electronic device 1000 according to an embodiment of this application. It should be noted that FIG. 1 merely shows some components included in the electronic device 1000 by using an example, and actual sizes, actual locations, and actual structures of these components are not limited by FIG. 1. The following accompanying drawings also merely show some components by using an example, and actual sizes, actual locations, and actual structures of these components are not limited by the following accompanying drawings. Details are not described below again.

As shown in FIG. 1, this application provides an electronic device 1000. The electronic device 1000 may be an intelligent wearable device such as augmented reality (augmented reality, AR) glasses, virtual reality (virtual reality, VR) glasses, mixed reality (mixed reality, MR) glasses, a VR headset, an AR headset, or an MR headset. The electronic device 1000 may alternatively be a head-up display (head-up display, HUD) device, a projector (projector), or the like. An example in which the electronic device 1000 in the embodiment shown in FIG. 1 is the AR glasses is used as an example for description.

As shown in FIG. 1, the electronic device 1000 may include a display panel 100, an eyeglass frame 200, and a lens 300. For example, the eyeglass frame 200 includes a front frame 210 and a temple 220. There may be two temples 220. The two temples 220 may be respectively connected to two ends of the front frame 210. The eyeglass frame 200 may constitute a bearing member of the electronic device 1000.

In some implementations, the lens 300 may be mounted on the front frame 210. The display panel 100 is mounted on the temple 220. In another implementation, a location of the display panel 100 is not specifically limited. It may be understood that a quantity of display panels 100 is not limited to 1 shown in FIG. 1. For example, there may be two display panels 100. The two display panels 100 may be respectively located on the two temples 220. There may alternatively be three display panels 100, and the display panels 100 are mounted on the temple 220 after being combined with x-cube. In addition, a quantity of lenses 300 is not limited to 2 shown in FIG. 1. For example, there may be one lens 300.

For example, an optical waveguide structure (not shown in the figure) may be disposed in the lens 300. In this way, when the display panel 100 emits a light ray, the light ray is transmitted to the optical waveguide structure, and is transmitted to the front of eyes of a user under adjustment of the optical waveguide structure. In this case, the user may see an image of the display panel 100.

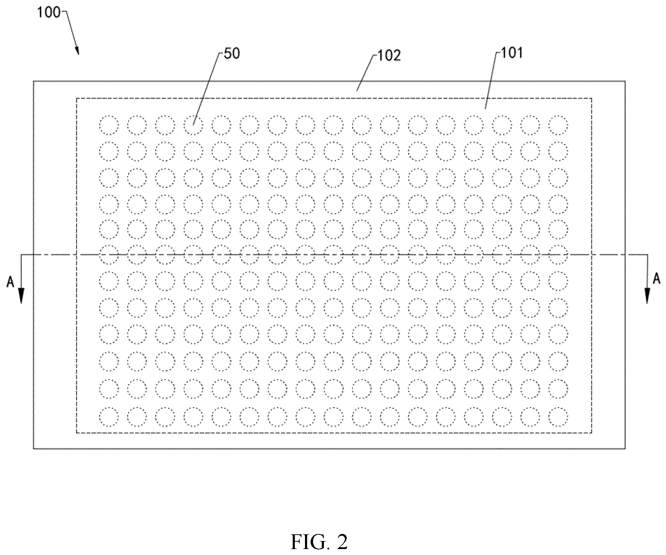

FIG. 2 is a diagram of a structure of an implementation of the display panel 100 shown in FIG. 1.

As shown in FIG. 2, the display panel 100 includes a display area 101 and a non-display area 102. The non-display area 102 is connected to the display area 101. The display area 101 is configured to display an image. The non-display area 102 is located around the display area 101. The non-display area 102 may be used to dispose a signal transmission line, and may be used to transmit an external signal to the display area 101.

In some implementations, the display panel 100 may be a micro-light emitting diode (Micro-LED) display panel. A structure of the display panel 100 has a plurality of settings, and details are described below with reference to related accompanying drawings.

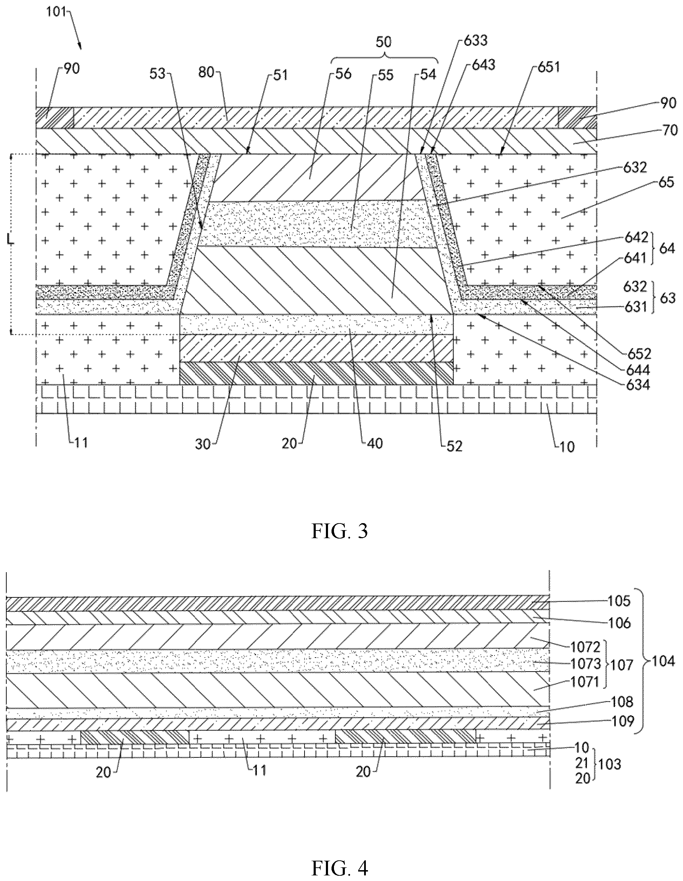

In some implementations, FIG. 3 is a partial sectional view of an implementation of the display panel 100 shown in FIG. 2 at a line A-A.

As shown in FIG. 3, the display area 101 of the display panel 100 may include a driver substrate 10, a first dielectric layer 11, a first electrode 20, a first reflection layer 30, a first conductive layer 40, a pixel structure 50, a passivation layer 63, a second reflection layer 64, a second dielectric layer 65, a second conductive layer 70, a first reflection grating 80, and a second electrode 90.

The driver substrate 10 may be configured to enable the pixel structure to emit light. For example, the driver substrate 10 may be a complementary metal oxide semiconductor (complementary metal oxide semiconductor, CMOS) backplane. The driver substrate 10 may include a driver circuit. The driver circuit may be an active matrix driver circuit, or the driver circuit may be a passive matrix driver circuit.

As shown in FIG. 3, the pixel structure 50 may be disposed on the driver substrate 10. It may be understood that one pixel structure 50 may be one pixel of the display panel 100.

In some implementations, the display panel 100 may include a plurality of pixel structures 50 spaced apart (as shown in FIG. 2). For example, the plurality of pixel structures 50 may be spaced apart on a surface of the driver substrate 10 along a first direction, to form a pixel group. A plurality of pixel groups may be spaced apart along a second direction. There is an included angle between the first direction and the second direction.

In some implementations, in a thickness direction of the display panel 100 (in other words, in a direction perpendicular to the driver substrate 10), a height of the pixel structure 50 may be within a range of 100 nanometers (nanometers, nm) to 10 micrometers (micrometers, $\mu$m), to be specific, the height of the pixel structure 50 is greater than or equal to 100 nanometers and less than or equal to 10 micrometers.

In some implementations, in a direction parallel to the driver substrate 10, a width of the pixel structure 50 may be within a range of 100 nm to 1 millimeter (millimeter, mm). In another implementation, the width of the pixel structure 50 may be within another range.

It may be understood that a size of the pixel structure 50 is small, and a large quantity of pixel structures 50 may be disposed in the limited display area 101 of the display panel 100. This helps improve pixel density of the display panel 100. Imaging quality of the display panel 100 is good. This helps a user see a clear image.

As shown in FIG. 3, the pixel structure 50 may include a top surface 51, a bottom surface 52, and a side surface 53. The top surface 51 is disposed opposite to the bottom surface 52, and the side surface 53 is connected between the top surface 51 and the bottom surface 52. The bottom surface 52 of the pixel structure 50 is oriented toward the driver substrate 10. The top surface 51 of the pixel structure 50 is oriented away from the driver substrate 10. It may be understood that the top surface 51 of the pixel structure 50 is a surface that is of the pixel structure 50 and that is close to a display side of the display panel 100. The bottom surface 52 of the pixel structure 50 is a surface that is of the pixel structure 50 and that is away from the display side of the display panel 100. The side surface 53 is a surface connected between the top surface 51 and the bottom surface 52.

A part of a light ray emitted by the pixel structure 50 may be emitted from the top surface 51 of the pixel structure 50, a part of the light ray may be emitted from the side surface 53 of the pixel structure 50, and a remaining part of the light ray may be emitted from the bottom surface 52 of the pixel structure 50.

For example, the pixel structure 50 may include a first semiconductor layer 54, a light emitting layer 55 (which may also be referred to as an active layer), and a second semiconductor layer 56 that are stacked. The light emitting layer 55 may include a top and a bottom. The top of the light emitting layer 55 is close to the display side of the display panel 100. The bottom of the light emitting layer 55 is away from the display side of the display panel 100. The light emitting layer 55 further includes a side surface. The side surface of the light emitting layer is a surface connected between the top and the bottom of the light emitting layer 55.

The first semiconductor layer 54 may be located at the bottom of the light emitting layer 55, and the second semiconductor layer 56 may be located at the top of the light emitting layer 55. In other words, the light emitting layer 55 may be located between the first semiconductor layer 54 and the second semiconductor layer 56. The first semiconductor layer 54 is located on a side that is of the light emitting layer 55 and that is close to the driver substrate 10.

It may be understood that, a surface that is of the first semiconductor layer 54 and that is away from the light emitting layer 55 may form the bottom surface 52 of the pixel structure 50. A surface that is of the second semiconductor layer 56 and that is away from the light emitting layer 55 may form the top surface 51 of the pixel structure 50. The side surface of the light emitting layer 55 may form a part of the side surface 53 of the pixel structure 50.

In some implementations, the first semiconductor layer 54 may be an N-type semiconductor layer, and the second semiconductor layer 56 may be a P-type semiconductor layer. In another implementation, the first semiconductor layer 54 may be a P-type semiconductor layer, and the second semiconductor layer 56 may be an N-type semiconductor layer.

The N-type semiconductor layer may include an N-type semiconductor, and the N-type semiconductor is a semiconductor that mainly performs electronic conduction. The P-type semiconductor layer includes a P-type semiconductor, and the P-type semiconductor is a semiconductor that mainly performs hole conduction. When the driver substrate 10 applies a current to the pixel structure 50, an electron at the first semiconductor layer 54 may be recombined with a hole at the second semiconductor layer 56, and energy is emitted in a photon form at a position of the light emitting layer 55, that is, light is emitted at the light emitting layer 55.

As shown in FIG. 3, the first electrode 20, the first reflection layer 30, and the first conductive layer 40 may be sequentially disposed at a bottom of the pixel structure 50. The first reflection layer 30 may be disposed between the pixel structure 50 and the driver substrate 10. For example, the first electrode 20 may be connected between the driver substrate 10 and the first reflection layer 30. The first reflection layer 30 may be located between the first electrode 20 and the first conductive layer 40. The first conductive layer 40 may be connected to the bottom surface 52 of the pixel structure 50.

It may be understood that the first reflection layer 30 may be disposed opposite to the pixel structure 50. In this way, the first reflection layer 30 may be configured to reflect, to a top of the pixel structure 50, the light ray emitted by the pixel structure 50 from the bottom surface 52. It should be understood that in this application, that a component A is disposed opposite to a component B may be that the component A is projected along a first target direction to obtain projection C, the component B is projected along a second target direction to obtain projection D, and the projection C and the projection D may at least partially overlap. The first target direction and the second target direction may be the same (where an error of a small angle is allowed). In this application, both the first target direction and the second target direction may be directions perpendicular to the driver substrate 10.

It may be understood that the first conductive layer 40 may be located between the first reflection layer 30 and the pixel structure 50, and the first conductive layer 40 may be configured to enable the first semiconductor layer 54 and the first reflection layer 30 to form a good ohmic contact, to reduce contact resistance. In another implementation, the display panel 100 may not include the first conductive layer 40. In this case, the first semiconductor layer 54 may be directly connected to the first reflection layer 30.

For example, the first electrode 20 may be disposed on the surface of the driver substrate 10. The first electrode 20 may be electrically connected to the driver substrate 10. The first electrode 20 may be configured to transmit a driver signal of the driver substrate 10. In an implementation, there may be a plurality of first electrodes 20, and the plurality of first electrodes 20 may be spaced apart. The plurality of first electrodes 20 and a plurality of pixel structures 50 may be disposed in one-to-one correspondence. In another implementation, the first electrode 20 may be disposed in a tiling manner at an entire layer, that is, there is one first electrode 20. In this way, one first electrode 20 may cover all pixel structures 50. Specifically, the following provides detailed descriptions with reference to related accompanying drawings.

The first reflection layer 30 may be disposed between the pixel structure 50 and the driver substrate 10. In an implementation, there may be a plurality of first reflection layers 30, and the plurality of first reflection layers 30 may be spaced apart. The plurality of first reflection layers 30 and the plurality of pixel structures 50 are disposed in one-to-one correspondence. In another implementation, the first reflection layer 30 may be disposed in a tiling manner at an entire layer, that is, there is one first reflection layer 30. In this way, one first reflection layer 30 may cover all pixel structures 50. Specifically, the following provides detailed descriptions with reference to related accompanying drawings.

In some implementations, the first reflection layer 30 may be of a single-layer structure. A material of the first reflection layer 30 may include one or more of silver (Ag), aluminum (Al), gold (Au), copper (Cu), chromium (Cr), nickel (Ni), platinum (Pt), titanium (Ti), and tungsten-titanium alloy (TiW).

In some implementations, the first reflection layer 30 may include a plurality of reflection sub-layers disposed in a stacked manner. A material of the reflection sub-layer may include one or more of silver (Ag), aluminum (Al), gold (Au), copper (Cu), chromium (Cr), nickel (Ni), platinum (Pt), titanium (Ti), and tungsten-titanium alloy (TiW). In other words, the first reflection layer 30 may be a metal-laminated layer. In the plurality of reflection sub-layers that may be included in the first reflection layer 30, materials of adjacent reflection sub-layers may be different. The first reflection layer 30 may include a plurality of reflection sub-layers of different materials.

It may be understood that the first reflection layer 30 may be a single metal layer or a metal-laminated layer. The first reflection layer 30 may reflect, to the top of the pixel structure 50, the light ray emitted by the pixel structure 50 from the bottom surface 52, and may be further used for current conduction. The driver signal generated by the driver substrate 10 may be transmitted to the pixel structure 50 by using the first reflection layer 30.

In some implementations, in the direction perpendicular to the driver substrate 10, a thickness of the first reflection layer 30 may be within a range of 5 nm to 1000 nm. For example, the thickness of the first reflection layer 30 may be 5 nm, 10 nm, or 1000 nm.

For example, the first conductive layer 40 may be connected between the first reflection layer 30 and the first semiconductor layer 54.

In an implementation, there may be a plurality of first conductive layers 40, and the plurality of first conductive layers 40 may be spaced apart. The plurality of first conductive layers 40 and the plurality of pixel structures 50 are disposed in one-to-one correspondence. In another implementation, the first conductive layer 40 may be disposed in a tiling manner at an entire layer, that is, there is one first conductive layer 40. In this way, one first conductive layer 40 may cover all pixel structures 50. Specifically, the following provides detailed descriptions with reference to related accompanying drawings.

For example, a material of the first conductive layer 40 may be a transparent conductive material, for example, indium tin oxide (indium tin oxide, ITO).

In some implementations, in the direction perpendicular to the driver substrate 10, a thickness of the first conductive layer 40 may be within a range of 0 nm to 500 nm. For example, the thickness of the first conductive layer 40 may be 5 nm, 10 nm, or 500 nm. In another implementation, in the direction perpendicular to the driver substrate 10, the thickness of the first conductive layer 40 may be greater than 500 nm.

In another implementation, the first conductive layer 40 may not be disposed on the display panel 100. Specifically, the following provides detailed descriptions with reference to related accompanying drawings.

As shown in FIG. 3, the first dielectric layer 11 may be disposed on the driver substrate 10. A material of the first dielectric layer 11 may be one or more of silicon dioxide ($SiO_2$), silicon nitride (SiNx), or silicon oxynitride (SiON).

The first electrode 20, the first reflection layer 30, and the first conductive layer 40 may all be embedded in the first dielectric layer 11.

As shown in FIG. 3, the passivation layer 63 may be connected to the side surface 53 of the pixel structure 50. The passivation layer 63 may be configured to insulate the side surface 53 of the pixel structure 50. For example, the passivation layer 63 may include a first bottom wall 631 and a first side wall 632 (where the first bottom wall 631 and the first side wall 632 are schematically distinguished by using dashed lines in FIG. 3). The first bottom wall 631 is connected to the first side wall 632. The first bottom wall 631 may be connected to the first dielectric layer 11. The first side wall 632 may be connected to the side surface 53 of the pixel structure 50.

The passivation layer 63 may include a top surface 633 and a bottom surface 634 that are disposed opposite to each other. The top surface 633 of the passivation layer 63 may be oriented away from the driver substrate 10. The bottom surface 634 of the passivation layer 63 may be connected to the first dielectric layer 11.

In some implementations, the passivation layer 63 may include a plurality of sub-passivation layers disposed in a stacked manner. Materials of different sub-passivation layers may be the same or may be different. A material of each sub-passivation layer may include silicon oxide, silicon nitride, and the like. In another implementation, the passivation layer 63 may include one sub-passivation layer.

In some implementations, thicknesses of the first bottom wall 631 and the first side wall 632 of the passivation layer 63 may be within a range of 0 nm to 500 nm. For example, the thicknesses of the first bottom wall 631 and the first side wall 632 of the passivation layer 63 may be 5 nm, 10 nm, or 500 nm. The thickness of the first bottom wall 631 is a thickness in the direction perpendicular to the driver substrate 10. The thickness of the first side wall 632 is a thickness in a direction perpendicular to the first side wall 632. In another implementation, the thicknesses of the first bottom wall 631 and the first side wall 632 of the passivation layer 63 may be within another range.

As shown in FIG. 3, the second reflection layer 64 is disposed on a side that is of the passivation layer 63 and that is away from the driver substrate 10. The second reflection layer 64 may be connected to the passivation layer 63. For example, the second reflection layer 64 may include a second bottom wall 641 and a second side wall 642 (where the second bottom wall 641 and the second side wall 642 are schematically distinguished by using dashed lines in FIG. 3). The second bottom wall 641 of the second reflection layer 64 may be connected to the first bottom wall 631 and the first side wall 632 of the passivation layer 63. The second side wall 642 of the second reflection layer 64 may be connected to the first side wall 632 of the passivation layer 63.

It may be understood that the passivation layer 63 may be connected between the second reflection layer 64 and the side surface 53 of the pixel structure 50, and between the second reflection layer 64 and the driver substrate 10. Therefore, the passivation layer 63 may be further configured to isolate the driver substrate 10 from the second reflection layer 64 and isolate the side surface 53 of the pixel structure 50 from the second reflection layer 64.

The second reflection layer 64 may include a top surface 643 and a bottom surface 644 that are disposed opposite to each other. The top surface 643 of the second reflection layer 64 may be oriented away from the driver substrate 10. The bottom surface 644 of the second reflection layer 64 may be connected to the passivation layer 63.

The second reflection layer 64 may be configured to reflect the light ray emitted by the pixel structure 50 from the side surface 53. In some implementations, a material of the second reflection layer 64 may be a material having a high visible light reflectivity. It may be understood that, for the material having a high visible light reflectivity, the reflectivity of the material for visible light is greater than an absorption rate of the material for the visible light. The second reflection layer 64 is prepared by using the material having a high visible light reflectivity. Most of the light ray emitted by the pixel structure 50 from the side surface 53 may be reflected back to the pixel structure 50 by the second reflection layer 64, then is refracted and emitted from the top surface 51 of the pixel structure 50, and is received by the user. In other words, the light ray emitted by the pixel structure 50 from the side surface 53 is received by the user as much as possible, instead of being absorbed by the second reflection layer 64, to reduce an energy loss.

In addition, the passivation layer 63 is disposed between the side surface 53 of the pixel structure 50 and the second reflection layer, so that the side surface 53 of the pixel structure 50 is not electrically connected to the second reflection layer 64 made of a metal material, and a risk of electric leakage on the side surface 53 of the pixel structure 50 is reduced. The passivation layer 63 may be configured to isolate adjacent pixel structures 50.

In some implementations, the material of the second reflection layer 64 may be a metal material having a high visible light reflectivity. In this way, when reflecting the light ray emitted by the pixel structure 50 from the side surface 53, the second reflection layer 64 may be further configured to assist the pixel structure 50 in heat dissipation.

In some implementations, the material of the second reflection layer 64 may include one or more of silver (Ag), aluminum (Al), gold (Au), copper (Cu), chromium (Cr), nickel (Ni), platinum (Pt), titanium (Ti), and tungsten-titanium alloy (TiW).

It may be understood that the second reflection layer 64 may alternatively be a single metal layer or a metal-laminated layer. When the second reflection layer 64 is made of a metal material, refer to a material setting of the first reflection layer 30.

In some implementations, the second reflection layer 64 may be a Distributed Bragg Reflector (Distributed Bragg Reflector, DBR) formed by dielectric materials having a plurality of different refractive indexes. For example, the second reflection layer 64 may include at least one second reflection unit (not shown in the figure). The second reflection unit may include a first reflection sub-layer and a second reflection sub-layer that are stacked. The second reflection sub-layer of the second reflection unit may be located on a side that is of the first reflection sub-layer of the second reflection unit and that is away from the driver substrate 10. Both a material of the first reflection sub-layer of the second reflection unit and a material of the second reflection sub-layer may be dielectric materials, and the materials of the first reflection sub-layer and the second reflection sub-layer of the second reflection unit may be different.

In some implementations, one of the material of the first reflection sub-layer of the second reflection unit and the material of the second reflection sub-layer of the second reflection unit may be silicon dioxide ($SiO_2$), and the other may be titanium dioxide ($TiO_2$). For example, the material of the first reflection sub-layer of the second reflection unit may be silicon dioxide ($SiO_2$), and the material of the second reflection sub-layer of the second reflection unit may be titanium dioxide ($TiO_2$).

The second reflection layer 64 may include one second reflection unit, or may include a plurality of second reflection units. Specifically, a quantity of second reflection units included in the second reflection layer 64 may be designed based on a requirement.

The second reflection layer 64 may be multi-periodic. To be specific, the second reflection layer 64 may include at least two second reflection units. In some implementations, the quantity of second reflection units included in the second reflection layer 64 may be greater than or equal to 1 and less than or equal to 100. For example, the quantity of second reflection units included in the second reflection layer 64 may be 1, 20, 50, or 100.

It may be understood that, when the second reflection layer 64 is a Distributed Bragg Reflector, materials and thicknesses of the first reflection sub-layer and the second reflection sub-layer in the second reflection layer 64 may be selected and designed based on a wavelength of a light ray that needs to be reflected, to reflect a target light ray with a specific wavelength. In some implementations, a wavelength of a target light ray that needs to be reflected by the second reflection layer 64 is A, a refractive index of a first light shield sub-layer of the second reflection unit is B, and a refractive index of a second light shield sub-layer of the second reflection unit is C.

The thickness of the first reflection sub-layer of the second reflection unit may be:

$$\frac{1}{4} \times \frac{A}{B} \pm 20 \text{ (nm)}.$$

The thickness of the second reflection sub-layer of the second reflection unit may be:

$$\frac{1}{4} \times \frac{A}{C} \pm 20 \text{ (nm)}.$$

In some implementations, thicknesses of the second bottom wall 641 and the second side wall 642 of the second reflection layer 64 may be within the range of 5 nm to 1000 nm. For example, the thickness may be 5 nm, 10 nm, or 1000 nm. The thickness of the second bottom wall 641 is a thickness in the direction perpendicular to the driver substrate 10. The thickness of the second side wall 642 is a thickness in the direction perpendicular to the first side wall 632.

In some implementations, a thickness of the passivation layer 63 may be 0 nm, in other words, the passivation layer 63 may not be disposed on the display panel 100. In this case, the second reflection layer 64 may be connected to the side surface 53 of the pixel structure 50.

As shown in FIG. 3, the second dielectric layer 65 may be disposed on a side that is of the second reflection layer 64 and that is away from the driver substrate 10, and the second dielectric layer 65 may be connected to the second reflection layer 64. A material of the second dielectric layer 65 may be an insulation dielectric material, for example, one or more of silicon dioxide ($SiO_2$), silicon nitride (SiNx), silicon oxynitride (SiON), or titanium dioxide ($TiO_2$). It may be understood that the second dielectric layer 65 may be a single layer, or may have a plurality of layers. That the second dielectric layer 65 has a plurality of layers means that the second dielectric layer 65 may include a plurality of sub-dielectric layers that are stacked, and materials of the sub-dielectric layers may be different.

The second dielectric layer 65 may include a top surface 651 and a bottom surface 652 that are disposed opposite to each other. The top surface 651 of the second dielectric layer 65 may be oriented away from the driver substrate 10. The bottom surface 652 of the second dielectric layer 65 may be connected to the second reflection layer 64.

In some implementations, the top surface 51 of the pixel structure 50 may be flush with the top surface 651 of the second dielectric layer 65, the top surface 643 of the second reflection layer 64, and the top surface 633 of the passivation layer 63. It should be noted that, the top surface 51 of the pixel structure 50 is not absolutely flush with the top surface 651 of the second dielectric layer 65, the top surface 643 of the second reflection layer 64, and the top surface 633 of the passivation layer 63, and this is within a range allowed by a process error. The top surface 51 of the pixel structure 50 may deviate from the top surface 651 of the second dielectric layer 65, the top surface 643 of the second reflection layer 64, and the top surface 633 of the passivation layer 63 to a specific extent. For example, there is a specific fluctuation setting. In this way, flatness between the top surface 51 of the pixel structure 50 and the top surface 651 of the second dielectric layer 65, the top surface 643 of the second reflection layer 64, and the top surface 633 of the passivation layer 63 is high.

As shown in FIG. 3, the second conductive layer 70 may be disposed on sides that are of the pixel structure 50, the passivation layer 63, the second reflection layer 64, and the second dielectric layer 65 and that are away from the driver substrate 10. For example, the second conductive layer 70 may be connected to the top surface 51 of the pixel structure 50, the top surface 651 of the second dielectric layer 65, the top surface 643 of the second reflection layer 64, and the top surface 633 of the passivation layer 63. It may be understood that the pixel structure 50, the passivation layer 63, the second reflection layer 64, and the second dielectric layer 65 may further provide support for the second conductive layer 70.

A material of the second conductive layer 70 may be a transparent conductive material. It may be understood that the second conductive layer 70 is located on a side that is of the pixel structure 50 and that is away from the driver substrate 10, and the second conductive layer 70 uses a transparent material and does not block the light ray emitted by the pixel structure 50. The second conductive layer 70 uses a conductive material, so that the second conductive layer 70 can be configured to be electrically connected to the pixel structure 50. When the driver substrate 10 applies a current to the pixel structure 50, the second conductive layer 70 may assist in diffusing the current, so that the current is more quickly diffused to the pixel structure 50 of the entire display panel 100, and light emitting uniformity of the display panel 100 is improved. When the material of the second reflection layer 64 is a metal material, the second reflection layer 64 may further be electrically connected to the second conductive layer 70. In this way, the second reflection layer 64 may also help the second conductive layer 70 transmit an electrical signal.

For example, the material of the second conductive layer 70 may be indium tin oxide (indium tin oxide, ITO).

In some implementations, in the direction perpendicular to the driver substrate 10, a thickness of the second conductive layer 70 may be within the range of 0 nm to 500 nm. For example, the thickness of the second conductive layer 70 may be 5 nm, 10 nm, or 100 nm. In another implementation, in the direction perpendicular to the driver substrate 10, the thickness of the second conductive layer 70 may be greater than 500 nm.

As shown in FIG. 3, the first reflection grating 80 may be disposed on a side that is of the second conductive layer 70 and that is away from the driver substrate 10, and is disposed opposite to the pixel structure 50. The second conductive layer 70 is connected between the pixel structure 50 and the first reflection grating 80. The first reflection grating 80 may be configured to reflect a light ray (namely, the target light ray) with a specific wavelength emitted by the light emitting layer 55 from the top surface 51 of the pixel structure 50.

In some implementations, the first reflection grating 80 may be a Distributed Bragg Reflector (Distributed Bragg Reflector, DBR) formed by dielectric materials having a plurality of different refractive indexes.

In some implementations, the first reflection grating 80 may include at least one first grating unit (not shown in the figure). The first grating unit may include a first reflection sub-grating and a second reflection sub-grating that are stacked. The first reflection sub-grating is located on a side that is of the second reflection sub-grating and that is close to the driver substrate 10. Both a material of the first reflection sub-grating and a material of the second reflection sub-grating may be dielectric materials, and the material of the first reflection sub-grating and the material of the second reflection sub-grating may be different.

In some implementations, one of the materials of the first reflection sub-grating and the second reflection sub-grating may be silicon dioxide ($SiO_2$), and the other may be titanium dioxide ($TiO_2$). For example, the material of the first reflection sub-grating may be silicon dioxide ($SiO_2$), and the material of the second reflection sub-grating may be titanium dioxide ($TiO_2$).

The first reflection grating 80 may include one first grating unit, or may include a plurality of first grating units. When the first reflection grating 80 includes a plurality of first grating units, the first reflection grating 80 may be a multi-periodic Distributed Bragg Reflector. The plurality of first grating units are disposed in a stacked manner. Specifically, a quantity of first grating units included in the first reflection grating 80 may be designed based on a requirement.

In some implementations, the quantity of first grating units included in the first reflection grating 80 may be within a range of 1 to 100. For example, the quantity of first grating units included in the first reflection grating 80 may be 1, 20, 50, or 100.

It may be understood that, the materials and thicknesses of the first reflection sub-grating and the second reflection sub-grating that are included in the first grating unit may be designed based on a specific wavelength of a target light ray that needs to be emitted, to reflect the target light ray. In some implementations, the wavelength of the target light ray that needs to be reflected by the first reflection grating 80 is A, a refractive index of the first reflection sub-grating of the first grating unit is D, and a refractive index of the second reflection sub-grating of the first grating unit is E.

The thickness of the first reflection sub-grating of the first grating unit may be:

$$\frac{1}{4} \times \frac{A}{D} \pm 20 \text{ (nm)}.$$

The thickness of the second reflection sub-grating of the first grating unit may be:

$$\frac{1}{4} \times \frac{A}{E} \pm 20 \text{ (nm)}.$$

It may be understood that, the first reflection grating 80 cooperates with the first reflection layer 30 to form a resonant cavity, and the resonant cavity may be configured to enable the light ray (namely, the target light ray) with a specific wavelength emitted by the light emitting layer 55 of the pixel structure 50 to resonate.

It may be understood that FIG. 3 merely shows the first reflection grating 80 and the first reflection layer 30 of the resonant cavity by using an example. A side wall of the resonant cavity may be formed by another component of the display panel 100, for example, the second reflection layer 64. Specifically, this is not limited in this application.

The first reflection sub-grating and the second reflection sub-grating of the first grating unit may have different refractive indexes. In some implementations, the refractive index of the first reflection sub-grating of the first grating unit is within a range of 1 to 5. The refractive index of the second reflection sub-grating of the first grating unit is within the range of 1 to 5.

In some implementations, a difference between the refractive index of the first reflection sub-grating of the first grating unit and the refractive index of the second reflection sub-grating is M, and M meets: M≥0.2. In another implementation, M may be less than 0.2.

It may be understood that, in the first grating unit, the refractive index of the first reflection sub-grating may be greater than the refractive index of the second reflection sub-grating, or the refractive index of the first reflection sub-grating may be less than the refractive index of the second reflection sub-grating. A larger difference M between the refractive index of the first reflection sub-grating and the refractive index of the second reflection sub-grating indicates a better reflection effect of the first reflection grating 80 on the target light ray.

In some implementations, a vertical cavity length L of the resonant cavity formed by the first reflection grating 80 and the first reflection layer 30 may be further designed, so that $L = (N \times A)/(2 \times \lambda)$. N is a positive integer, A is a light emitting wavelength of the target light ray, and $\lambda$ is a refractive index of the first reflection grating 80 for the target light ray. The vertical cavity length L may be a distance between the first reflection grating 80 and the first reflection layer 30 in the thickness direction of the display panel 100.

In some implementations, in the thickness direction of the display panel 100, the vertical cavity length L of the resonant cavity may be within a range of 0.5 micrometers to 4 micrometers. For example, in the thickness direction of the display panel 100, the vertical cavity length L of the resonant cavity may be within a range of 1 micrometer to 2 micrometers.

It may be understood that the vertical cavity length L is set, so that resonance enhancement can be generated for the target light ray with a specific wavelength, to enhance light emitted in a normal direction of the display panel 100. After resonance enhancement is performed on the target light ray in the resonant cavity, a part of the target light ray may be emitted from the top surface 51 of the pixel structure 50, pass through the first reflection grating 80, finally become an output light ray of the display panel 100, and be received by the user.

In addition, the vertical cavity length L of the resonant cavity, and the thicknesses and the materials of the first reflection grating 80 and the first reflection layer 30 may be selected based on the wavelength of the target light ray, so that the formed resonant cavity performs resonance enhancement for the target light ray with a specific wavelength. A light ray with another wavelength is not enhanced, and the first reflection grating 80 causes partial blocking. The enhanced target light ray is finally emitted from the display panel 100 and received by the user. Therefore, the resonant cavity can improve light emitting efficiency of the display panel 100 and reduce a half width of a light emitting spectrum of the light ray emitted by the pixel structure 50.

In some implementations, a spectral half-peak width of the light ray emitted by the display panel 100 is within a range of 5 nanometers to 100 nanometers. It may be understood that a smaller spectral half-peak width of the light ray emitted by the display panel 100 indicates better color rendering performance of the display panel 100.

In addition, the resonant cavity may generate resonance for a light ray in a direction perpendicular to the display panel 100 and a nearby light ray. Therefore, light emitted in the direction (normal direction) perpendicular to the display panel 100 is enhanced, and a light ray with a large deviation angle from the normal direction is weakened. Therefore, the resonant cavity may further play a role of regulating and reducing light emitting angle distribution of the display panel 100.

In some implementations, a light emitting angle of the display panel 100 may be less than 40°. For example, the light emitting angle of the display panel 100 may be 30°. It may be understood that the light emitting angle of the display panel 100 is within a small range, and light emitting efficiency is high. When the display panel 100 is used in augmented reality (augmented reality, AR) glasses, virtual reality (virtual reality, VR) glasses, a head-up display (head-up display, HUD) device, or the like, the display panel 100 may be better coupled to an optical waveguide structure or have a better projection effect.

In some implementations, the light emitting angle of the display panel 100 may be less than 60°.

In some implementations, the light emitting angle of the display panel 100 may be less than 90°.

As shown in FIG. 3, the second electrode 90 may be disposed on the side that is of the second conductive layer 70 and that is away from the driver substrate 10. One end of the second electrode 90 may be connected to the driver substrate 10, and the other end may be connected to the second conductive layer 70. The second conductive layer 70 is electrically connected to the second semiconductor layer 56. In some implementations, the second electrode 90 may pass through the first reflection grating 80 and be connected to the second conductive layer 70. The second electrode 90 may be configured to be electrically connected to the second conductive layer 70, and the second conductive layer 70 may be electrically connected to the second semiconductor layer 56 of the pixel structure 50, so that the driver signal of the driver substrate 10 can be transmitted to the pixel structure 50.

In some implementations, in the direction perpendicular to the display panel 100, projection of the second electrode 90 on the driver substrate 10 and projection of the pixel structure 50 on the driver substrate 10 may be disposed in a staggered manner. In this way, the second electrode 90 may not block the light ray emitted by the pixel structure 50 from the top surface 51.

In some implementations, the second conductive layer 70 may not be disposed on the display panel 100. The first reflection grating 80 may be disposed on a side that is of the pixel structure 50 and that is away from the first reflection layer 30. The second electrode 90 may be directly connected to the pixel structure 50.

As shown in FIG. 3, the display area 101 of the display panel 100 in this application includes the driver substrate 10, the pixel structure 50, the first reflection layer 30, the first reflection grating 80, and the second reflection layer 64. The driver substrate 10, the first reflection layer 30, and the pixel structure 50 are sequentially disposed. The first reflection layer 30 and the first reflection grating 80 may form the resonant cavity. The resonant cavity may enable the light (namely, the target light ray) with a specific wavelength emitted by the light emitting layer 55 of the pixel structure 50 to resonate back and forth between the first reflection layer 30 and the first reflection grating 80, so that the target light ray can generate resonance enhancement, to enhance the light emitted in the normal direction of the display panel 100.

The vertical cavity length L of the resonant cavity, and the thicknesses and the materials of the first reflection grating 80 and the first reflection layer 30 may be selected based on the wavelength of the target light ray, so that the formed resonant cavity performs resonance enhancement for the target light ray with a specific wavelength. A light ray with another wavelength is not enhanced, and the first reflection grating 80 causes partial blocking. The enhanced target light ray is finally emitted from the display panel 100, and is received by the user, so that the resonant cavity can achieve the effect of improving light emitting efficiency of the display panel 100 and reducing the half width of the light emitting spectrum of the light ray emitted by the pixel structure 50.

The resonant cavity formed by the first reflection layer 30 and the first reflection grating 80 may generate resonance for a light ray in a direction perpendicular to a light emitting surface of the display panel 100 and a nearby light ray. Therefore, the resonant cavity enhances the light emitted in the normal direction, and the light ray with a large deviation angle from the normal direction is weakened. Therefore, the resonant cavity may further play the role of regulating and reducing light emitting angle distribution of the display panel 100.

The second reflection layer 64 is connected to the side surface 53 of the pixel structure 50, and can reflect the light ray emitted by the pixel structure 50 from the side surface 53, to avoid a problem of optical crosstalk between two adjacent pixel structures 50. To be specific, a light ray emitted by one of the pixel structures 50 from a side surface 53 is not easily propagated to the other pixel structure 50. Particularly, when the display panel 100 displays a frame of picture, if one of the two adjacent pixel structures 50 needs to emit light and the other does not emit light, crosstalk of a light ray of the pixel structure 50 that emits light to the pixel structure 50 that does not emit light does not easily occur. The second reflection layer 64 reflects the light ray emitted by the pixel structure 50 from the side surface 53, so that most of the light ray emitted by the pixel structure 50 from the side surface 53 can be reflected back to the pixel structure 50 by the second reflection layer 64, and then is emitted from the top surface 51 of the pixel structure 50 and received by the user, to improve light emitting intensity of a front surface of the display panel 100.

The foregoing specifically describes an implementation of the display panel 100 with reference to related accompanying drawings. The following specifically describes a preparation method of the display panel 100 in the foregoing implementation with reference to related accompanying drawings.

FIG. 4 to FIG. 8 are partial sectional views of some corresponding preparation steps in a preparation method of a display panel 100. As shown in FIG. 4 to FIG. 8, the preparation method of the display panel 100 provided in some implementations includes the following steps.

Step 1: Form a driver backplane 103. A first electrode 20 and a first dielectric layer 11 are formed on a surface of a driver substrate 10. The first electrode 20 may be embedded in the first dielectric layer 11.

Step 2: Form an epitaxial backplane 104. The epitaxial backplane 104 may include an epitaxial substrate 105, an epitaxial buffer layer 106, a to-be-processed pixel layer 107, a to-be-processed first conductive layer 108, and a to-be-processed reflection layer 109. The epitaxial buffer layer 106 may be located on the epitaxial substrate 105. The to-be-processed pixel layer 107 may be located between the epitaxial buffer layer 106 and the to-be-processed first conductive layer 108. The to-be-processed first conductive layer 108 may be located between the to-be-processed pixel layer 107 and the to-be-processed reflection layer 109.

For example, the to-be-processed pixel layer 107 includes a to-be-processed first semiconductor layer 1071, a to-be-processed second semiconductor layer 1072, and a to-be-processed light emitting layer 1073. The to-be-processed second semiconductor layer 1072 may be connected to the epitaxial buffer layer 106. The to-be-processed light emitting layer 1073 is located between the to-be-processed first semiconductor layer 1071 and the to-be-processed second semiconductor layer 1072.

It should be noted that step 1 and step 2 may be performed at the same time, to reduce processing duration.

Step 3: Bond the driver backplane 103 and the epitaxial backplane 104, as shown in FIG. 4. In some implementations, the to-be-processed first conductive layer 108 may be bonded together with the first electrode 20 and a second dielectric layer 65 by using the to-be-processed reflection layer 109.

Step 4: Remove the epitaxial substrate 105 and the epitaxial buffer layer 106.

For example, a method for removing the epitaxial substrate 105 and the epitaxial buffer layer 106 may be mechanical thinning, polishing, or etching.

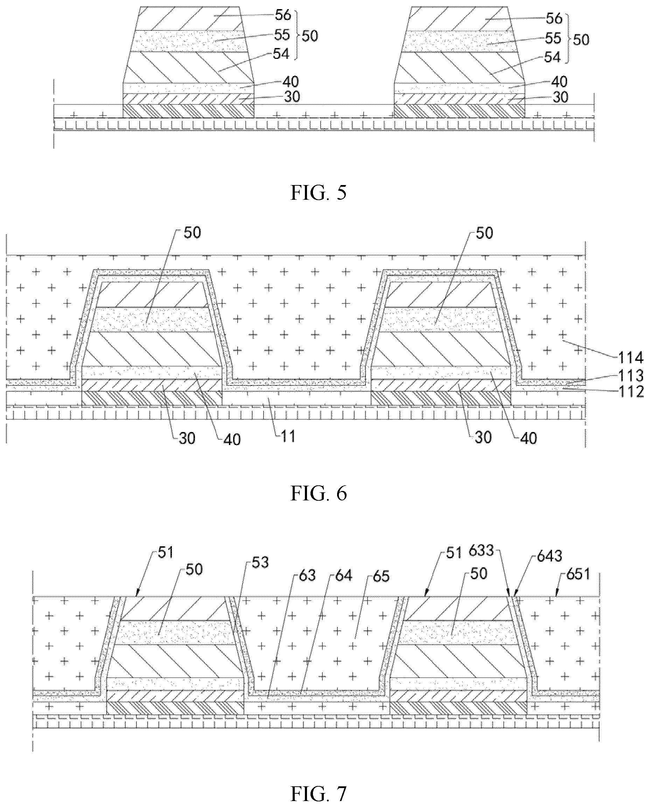

Step 5: Etch the to-be-processed pixel layer 107, the to-be-processed first conductive layer 108, and the to-be-processed reflection layer 109 based on a defined shape, a defined size, and defined distribution of a pixel structure 50, to form a plurality of pixel structures 50 that are spaced apart, first reflection layers 30, and first conductive layers 40, as shown in FIG. 5.

For example, the to-be-processed pixel layer 107, the to-be-processed first conductive layer 108, and the to-be-processed reflection layer 109 are etched, and the plurality of pixel structures 50 that are spaced apart, first reflection layers 30, and first conductive layers 40 are formed after exposure and development. The pixel structure 50 may include a first semiconductor layer 54, a light emitting layer 55, and a second semiconductor layer 56 that are stacked. The light emitting layer 55 is located between the first semiconductor layer 54 and the second semiconductor layer 56, the second semiconductor layer 56 is located on a side that is of the light emitting layer 55 and that is away from the driver substrate 10.

Step 6: Deposit a to-be-processed passivation layer 112, a to-be-processed light shield layer 113, and a to-be-processed dielectric layer 114 between the pixel structures 50, as shown in FIG. 6.

For example, the to-be-processed passivation layer 112 is deposited by using a deposition process. The to-be-processed passivation layer 112 covers the pixel structure 50, the first reflection layer 30, and the first conductive layer 40. The to-be-processed passivation layer 112 is connected to the pixel structure 50, the first reflection layer 30, the first conductive layer 40, and the first dielectric layer 11.

The to-be-processed light shield layer 113 is deposited by using the deposition process on a side that is of the to-be-processed passivation layer 112 and that is away from the driver substrate 10. The to-be-processed light shield layer 113 may be connected to the to-be-processed passivation layer 112. A start position for depositing the to-be-processed light shield layer 113 may be lower than or flush with a bottom surface of the first semiconductor layer 54.

The to-be-processed dielectric layer 114 is deposited by using the deposition process on a side that is of the to-be-processed light shield layer 113 and that is away from the driver substrate 10. The to-be-processed dielectric layer 114 may be connected to the to-be-processed light shield layer 113.

Step 7: Process the to-be-processed passivation layer 112, the to-be-processed light shield layer 113, and the to-be-processed dielectric layer 114, to form a passivation layer 63, a second reflection layer 64, and a second dielectric layer 65, as shown in FIG. 7. The passivation layer 63 may be connected to a side surface 53 of the pixel structure 50. The second reflection layer 64 is disposed on a side that is of the passivation layer 63 and that is away from the driver substrate 10. The second reflection layer 64 may be connected to the passivation layer 63. The second dielectric layer 65 may be disposed on a side that is of the second reflection layer 64 and that is away from the driver substrate 10, and the second dielectric layer 65 may be connected to the second reflection layer 64.

For example, a top surface 51 of the pixel structure 50 may be flush with a top surface 651 of the second dielectric layer 65, a top surface 643 of the second reflection layer 64, and a top surface 633 of the passivation layer 63.

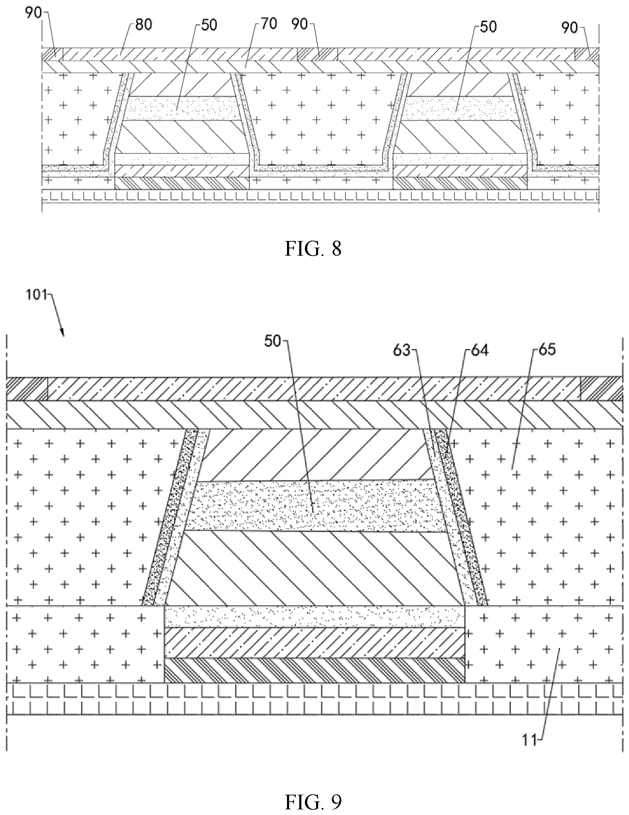

Step 8: Form a second conductive layer 70 on sides that are of the pixel structure 50 and a filling layer 60 and that are away from the driver substrate 10, and form a first reflection grating 80 and a second electrode 90 on a side that is of the second conductive layer 70 and that is away from the driver substrate 10, as shown in FIG. 8. The first reflection grating 80 may be disposed opposite to the pixel structure 50. In a direction perpendicular to the display panel 100, projection of the second electrode 90 on the driver substrate 10 and projection of the pixel structure 50 on the driver substrate 10 may be disposed in a staggered manner.

It may be understood that the display panel 100 is prepared by using the foregoing step 1 to step 8.

A display area 101 of the display panel 100 includes the driver substrate 10, the pixel structure 50, the first reflection layer 30, the first reflection grating 80, and the second reflection layer 64. The driver substrate 10, the first reflection layer 30, and the pixel structure 50 are sequentially disposed, in other words, the pixel structure 50 is disposed between the first reflection layer 30 and the first reflection grating 80. The first reflection layer 30 and the first reflection grating 80 may form a resonant cavity. The resonant cavity may enable light (namely, a target light ray) with a specific wavelength emitted by the light emitting layer 55 of the pixel structure 50 to resonate back and forth between the first reflection layer 30 and the first reflection grating 80. A vertical cavity length L is set, so that the target light ray can generate resonance enhancement, to enhance light emitted in a normal direction of the display panel 100.

The vertical cavity length L of the resonant cavity, and thicknesses and materials of the first reflection grating 80 and the first reflection layer 30 may be selected based on the wavelength of the target light ray, so that the formed resonant cavity performs resonance enhancement for the target light ray with a specific wavelength. A light ray with another wavelength is not enhanced, and the first reflection grating 80 causes partial blocking. The enhanced target light ray is finally emitted from the display panel 100, and is received by a user, so that the resonant cavity can improve light emitting efficiency of the display panel 100 and reduce a half width of a light emitting spectrum of the light ray emitted by the pixel structure 50.

In addition, the resonant cavity formed by the first reflection layer 30 and the first reflection grating 80 may generate resonance for a light ray in a direction perpendicular to a light emitting surface of the display panel 100 and a nearby light ray. Therefore, the resonant cavity enhances the light emitted in the normal direction, and a light ray with a large deviation angle from the normal direction is weakened. Therefore, the resonant cavity may further play a role of regulating and reducing light emitting angle distribution of the display panel 100.

The second reflection layer 64 is connected to the side surface 53 of the pixel structure 50, and can reflect the light ray emitted by the pixel structure 50 from the side surface 53, to avoid a problem of optical crosstalk between two adjacent pixel structures 50. To be specific, a light ray emitted by one of the pixel structures 50 from a side surface 53 is not easily propagated to the other pixel structure 50. Particularly, when the display panel 100 displays a frame of picture, if one of the two adjacent pixel structures 50 needs to emit light and the other does not emit light, crosstalk of a light ray of the pixel structure 50 that emits light to the pixel structure 50 that does not emit light does not easily occur. The second reflection layer 64 reflects the light ray emitted by the pixel structure 50 from the side surface 53, so that most of the light ray emitted by the pixel structure 50 from the side surface 53 can be reflected back to the pixel structure 50 by the second reflection layer 64, and then is emitted from the top surface 51 of the pixel structure 50 and received by the user, to improve light emitting intensity of a front surface of the display panel 100.

FIG. 9 is a partial sectional view of still another implementation of the display panel 100 shown in FIG. 3.

As shown in FIG. 9, the passivation layer 63 may alternatively not include the first bottom wall 631. The second reflection layer 64 may alternatively not include the second bottom wall 641. In this case, the passivation layer 63 may include a plurality of first side walls 632 spaced apart, and the first side wall 632 is connected to the side surface 53 of the pixel structure 50. The second reflection layer 64 may include a plurality of second side walls 642 spaced apart. The second side wall 642 is connected to a surface on a side that is of the first side wall 632 and that is away from the pixel structure 50. Alternatively, the second dielectric layer 65 and the second reflection layer 64 may be directly connected to the first dielectric layer 11.

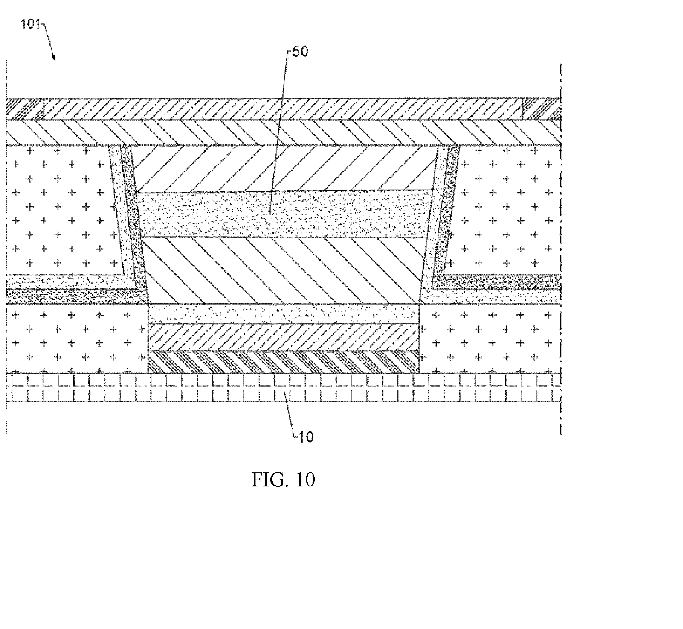

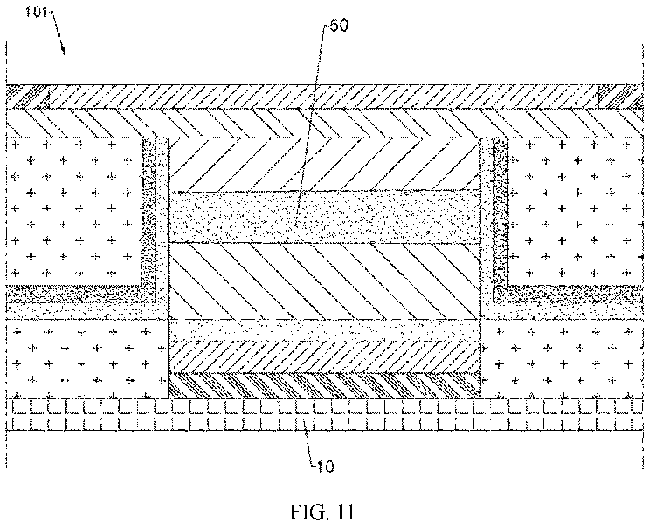

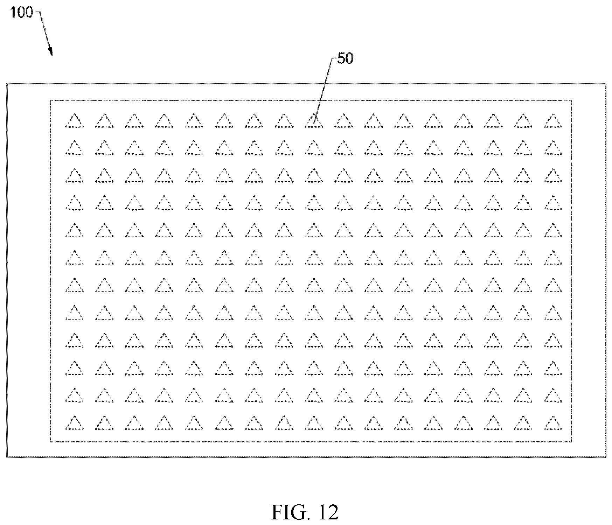

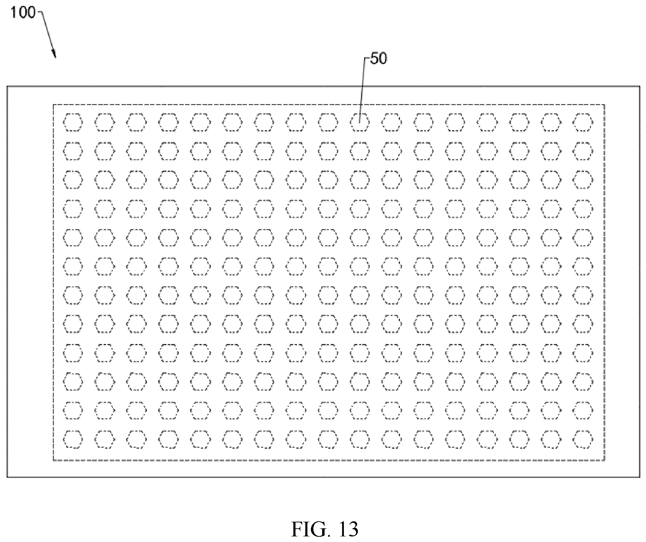

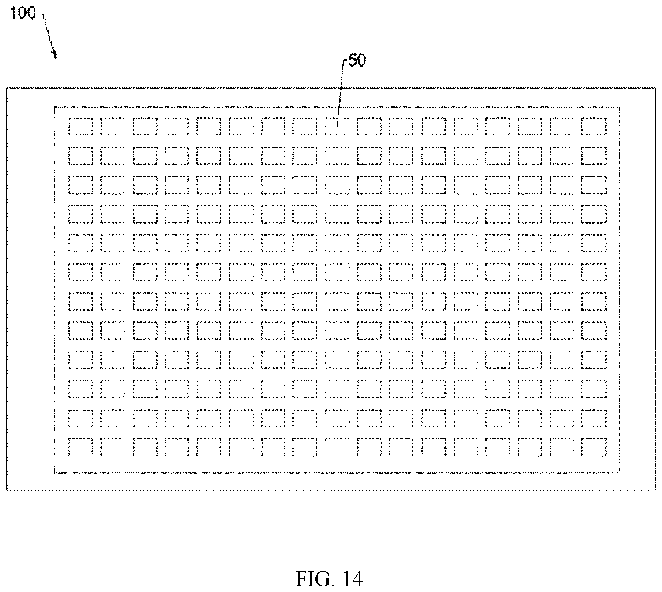

In some implementations, technical content that is the same as that of the display panel 100 in the foregoing implementations is not described again. FIG. 10 is a diagram of a structure of another implementation of the display panel 100 shown in FIG. 3. FIG. 11 is a diagram of a structure of still another implementation of the display panel 100 shown in FIG. 3. FIG. 12 is a diagram of a structure of still another implementation of the display panel 100 shown in FIG. 2. FIG. 13 is a diagram of a structure of still another implementation of the display panel 100 shown in FIG. 2. FIG. 14 is a diagram of a structure of still another implementation of the display panel 100 shown in FIG. 2.

In some implementations, the pixel structure 50 may be in a truncated cone shape, a cylinder shape, or a prism shape as a whole. The pixel structure 50 in the truncated cone shape may further be in a regular truncated cone shape (as shown in FIG. 9), or an inverted truncated cone shape (as shown in FIG. 10).

For the pixel structure 50 in the cylinder shape or the prism shape, in the direction perpendicular to the driver substrate 10, a cross section of the pixel structure 50 may be a rectangle (as shown in FIG. 11). In the direction parallel to the driver substrate 10, the cross section of the pixel structure 50 may be a circle (as shown in FIG. 2), a triangle (as shown in FIG. 12), a regular hexagon (as shown in FIG. 13), a rectangle (as shown in FIG. 14), or the like.

In another implementation, in the direction parallel to the driver substrate 10, the cross section of the pixel structure 50 may be an irregular polygon or a regular polygon such as a square, a rectangle, or a pentagon. It may be understood that a person skilled in the art may adaptively set a specific shape of the pixel structure 50 based on a specific situation.

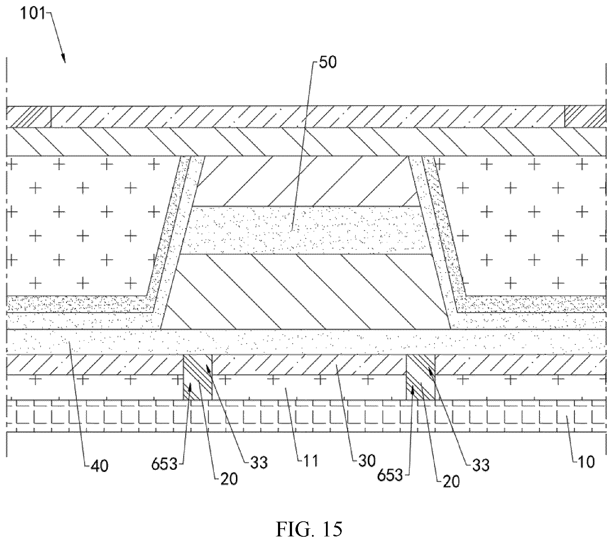

In some implementations, technical content that is the same as that of the display panel 100 (as shown in FIG. 3) in the foregoing implementations is not described again. FIG. 15 is a partial sectional view of another implementation of the display panel 100 shown in FIG. 2 at A-A.

As shown in FIG. 15, a first reflection layer 30 may be a Distributed Bragg Reflector (Distributed Bragg Reflector, DBR) formed by dielectric materials having a plurality of different refractive indexes. The first reflection layer 30 may be configured to reflect a light ray emitted from a bottom surface 52 of a pixel structure 50 disposed opposite to the first reflection layer 30.

The first reflection layer 30 may be disposed between a driver substrate 10 and the pixel structure 50. A first conductive layer 40 may be disposed on a side that is of the first reflection layer 30 and that is away from the driver substrate 10. The first conductive layer 40 may be electrically connected to the pixel structure 50.

A first electrode 20 may be embedded in a first dielectric layer 11 and the first reflection layer 30. For example, the first reflection layer 30 may be provided with a first through hole 33, the first dielectric layer 11 may be provided with a second through hole 653, and the first through hole 33 is in communication with the second through hole 653. The first electrode 20 may be located in the first through hole 33 and the second through hole 653. The first electrode 20 may pass through the first through hole 33 and the second through hole 653 and be connected to the driver substrate 10 and the first conductive layer 40. In this way, a driver signal of the driver substrate 10 may be transmitted to the pixel structure 50 by using the first electrode 20 and the first conductive layer 40.

In some implementations, a quantity of first through holes 33, a quantity of second through holes 653, and a quantity of pixel structures 50 may be equal. In another implementation, the quantity of first through holes 33 and the quantity of second through holes 653 may be greater than the quantity of pixel structures 50. For example, one pixel structure 50 corresponds to two first through holes 33 and two second through holes 653 (as shown in FIG. 15).

In some implementations, the first reflection layer 30 may be directly disposed on the driver substrate 10, and the pixel structure 50 is connected to the first reflection layer 30. The first reflection layer 30 may be provided with the first through hole 33. The first electrode 20 may be located in the first through hole 33. One end of the first electrode 20 may be electrically connected to the driver substrate 10, and the other end may pass through the first through hole 33 and be electrically connected to the pixel structure 50. In some implementations, the first reflection layer 30 may include at least one first reflection unit (not shown in the figure). The first reflection unit may include a first reflection sub-layer and a second reflection sub-layer that are stacked. The first reflection sub-layer in the first reflection unit may be located on a side that is of the second reflection sub-layer and that is close to the driver substrate 10. A material of the first reflection sub-layer of the first reflection unit and a material of the second reflection sub-layer of the first reflection unit may be different.

Both the material of the first reflection sub-layer of the first reflection unit and the material of the second reflection sub-layer may be dielectric materials. In some implementations, one of the materials of the first reflection sub-layer and the second reflection sub-layer of the first reflection unit may be silicon dioxide ($SiO_2$), and the other may be titanium dioxide ($TiO_2$). For example, the material of the first reflection sub-layer of the first reflection unit may be silicon dioxide ($SiO_2$), and the material of the second reflection sub-layer of the first reflection unit may be titanium dioxide ($TiO_2$).

The first reflection layer 30 may include one first reflection unit, or may include a plurality of first reflection units. Specifically, a quantity of first reflection units included in the first reflection layer 30 may be designed based on a requirement. In some implementations, the quantity of first reflection units included in the first reflection layer 30 may be within a range of 1 to 100. For example, the quantity of reflection units included in the first reflection layer 30 may be 1, 10, 30, or 100.

It may be understood that, the materials and corresponding thicknesses of the first reflection sub-layer and the second reflection sub-layer of the first reflection unit may be designed based on a wavelength of a light ray that needs to be reflected, to reflect a target light ray with a specific wavelength. In some implementations, the wavelength of the target light ray that needs to be reflected by the first reflection layer 30 is A, a refractive index of the first reflection sub-layer of the first reflection unit is F, and a refractive index of the second reflection sub-layer of the first reflection unit is G.

The thickness of the first reflection sub-layer of the first reflection unit may be:

$$\frac{1}{4} \times \frac{A}{F} \pm 20 \text{ (nm)}.$$

The thickness of the second reflection sub-layer of the first reflection unit may be:

$$\frac{1}{4} \times \frac{A}{G} \pm 20 \text{ (nm)}.$$

In some implementations, the display panel 100 may not include the first conductive layer 40. The first electrode 20 may pass through the first through hole 33 and the second through hole 653 and be directly connected to the pixel structure 50, so that an electrical signal of the driver substrate 10 can be directly transmitted to the pixel structure 50 by using the first electrode 20.

It may be understood that, compared with a solution in which only a first electrode 20 is disposed to transmit an electrical signal, in this solution, the first conductive layer 40 may be added to increase an electrical conduction area with the pixel structure 50, to improve reliability of electrical signal transmission.

In some implementations, the first conductive layer 40 may be disposed in a tiling manner at an entire layer (as shown in FIG. 15). In this way, a current can be more quickly diffused to the pixel structure 50 of the entire display panel 100, to improve light emitting uniformity of the display panel 100.

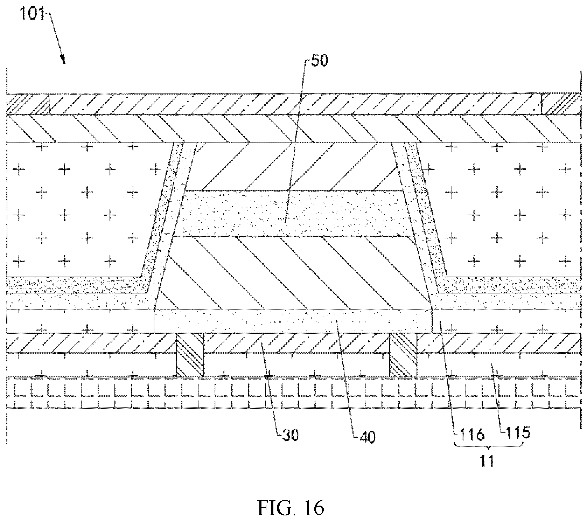

FIG. 16 is a partial sectional view of still another implementation of the display panel 100 shown in FIG. 2 at A-A.

As shown in FIG. 16, there may be a plurality of first conductive layers 40, and the first conductive layer 40 may be connected between a first reflection layer 30 and a pixel structure 50. A first dielectric layer 11 may include a first part 115 and a second part 116. A first electrode 20 is embedded in the first part 115. The first conductive layer 40 is embedded in the second part 116.

A quantity of first conductive layers 40 and a quantity of pixel structures 50 on the display panel 100 may be set in one-to-one correspondence. It may be understood that the quantity and locations of the first conductive layers 40 may be adjusted based on an actual situation. This is not limited in this application.

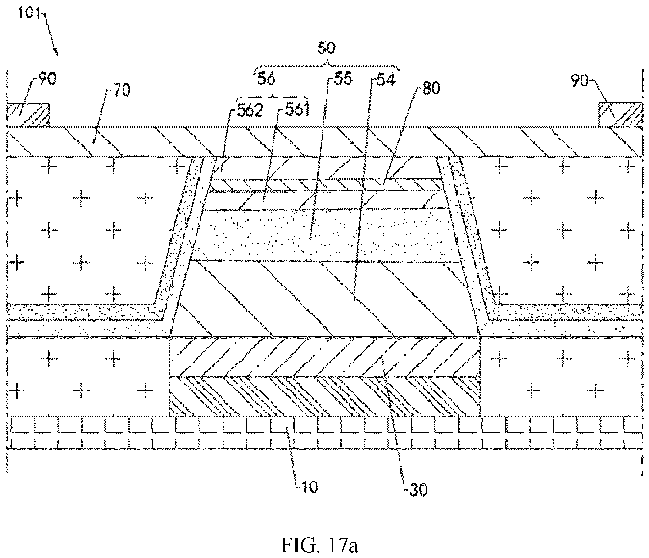

In some implementations, technical content that is the same as that of the display panel 100 (as shown in FIG. 3) in the foregoing implementations is not described again. FIG. 17a is a partial sectional view of yet another implementation of the display panel 100 shown in FIG. 2 at A-A.

As shown in FIG. 17a, a first reflection grating 80 may be disposed in a pixel structure 50. For example, the first reflection grating 80 may be disposed in a second semiconductor layer 56 of the pixel structure 50. The first reflection grating 80 may be electrically connected to a second semiconductor layer 56. A second conductive layer 70 may be disposed on a side that is of the pixel structure 50 and that is away from a driver substrate 10, and a second electrode 90 may be disposed on a side that is of the second conductive layer 70 and that is away from the driver substrate 10.

For example, the second semiconductor layer 56 may include a first part 561 and a second part 562, the first reflection grating 80 may be disposed between the first part 561 of the second semiconductor layer 56 and the second part 562 of the second semiconductor layer 56, and the first reflection grating 80 may be configured to electrically connect the first part 561 of the second semiconductor layer 56 and the second part 562 of the second semiconductor layer 56.

In another implementation, the first reflection grating 80 may be connected to a side that is of the second semiconductor layer 56 and that is away from the driver substrate 10, in other words, the first reflection grating 80 may be connected between the second semiconductor layer 56 and the second conductive layer 70. Alternatively, the first reflection grating 80 may be connected between a light emitting layer 55 and the second semiconductor layer 56. It may be understood that the first reflection grating 80 may be disposed on a side that is of the light emitting layer 55 of the pixel structure 50 and that is away from the driver substrate 10. In this way, the first reflection grating 80 and a first reflection layer 30 may form a resonant cavity, to enable light with a specific wavelength emitted by the light emitting layer 55 to resonant.

The first reflection grating 80 may be a multi-periodic DBR that is alternately formed by a plurality of epitaxial materials having a refractive index difference.

For example, the first reflection grating 80 may include at least one first grating unit (not shown in the figure). The first grating unit may include a first reflection sub-grating and a second reflection sub-grating that are stacked. The first reflection sub-grating may be located on a side that is of the second reflection sub-grating and that is close to the driver substrate 10. A material of the first reflection sub-grating of the first grating unit and a material of the second reflection sub-grating are different.

Both the material of the first reflection sub-grating of the first grating unit and the material of the second reflection sub-grating may be epitaxial materials.

In some implementations, one of the materials of the first reflection sub-grating and the second reflection sub-grating of the first grating unit may be aluminum gallium nitride (AlGaN), and the other may be gallium nitride (GaN).

In some implementations, one of the materials of the first reflection sub-grating and the second reflection sub-grating of the first grating unit may be aluminum indium gallium nitride (AlInGaN), and the other may be gallium nitride (GaN).

In another implementation, one of the materials of the first reflection sub-grating and the second reflection sub-grating of the first grating unit may be aluminum gallium arsenide (AlGaAs), and the other may be gallium arsenide (GaAs).

In some implementations, the first reflection sub-grating and the second reflection sub-grating that are included in the first grating unit may be formed through in-situ growth in a process of epitaxial growth of a material wafer of the pixel structure 50.

The first reflection sub-grating and the second reflection sub-grating of the first grating unit may have different refractive indexes. In some implementations, the refractive index of the first reflection sub-grating of the first grating unit is within a range of 1 to 5. The refractive index of the second reflection sub-grating of the first grating unit is within the range of 1 to 5.

In some implementations, a difference between the refractive index of the first reflection sub-grating of the first grating unit and the refractive index of the second reflection sub-grating is M, and M meets: M≥0.2. In another implementation, M may be less than 0.2.

It may be understood that, in the first grating unit, the refractive index of the first reflection sub-grating may be greater than the refractive index of the second reflection sub-grating, or the refractive index of the first reflection sub-grating may be less than the refractive index of the second reflection sub-grating. A larger difference M between the refractive index of the first reflection sub-grating and the refractive index of the second reflection sub-grating indicates a better reflection effect of the first reflection grating 80 on a target light ray.

It may be understood that, a material of the first reflection grating 80 may correspond to a material doping type of the second semiconductor layer 56, and n-type or p-type doping is performed, to implement conductivity.

In some implementations, the display panel 100 may include a plurality of first reflection gratings 80, and the plurality of first reflection gratings 80 may be disposed opposite to a plurality of pixel structures 50 in one-to-one correspondence. To be specific, a quantity of first reflection gratings 80 may be equal to a quantity of pixel structures 50, and the first reflection grating 80 may be disposed opposite to the pixel structure 50 corresponding to the first reflection grating 80. In this way, the first reflection grating 80 may be configured to reflect the light ray emitted by the pixel structure 50.

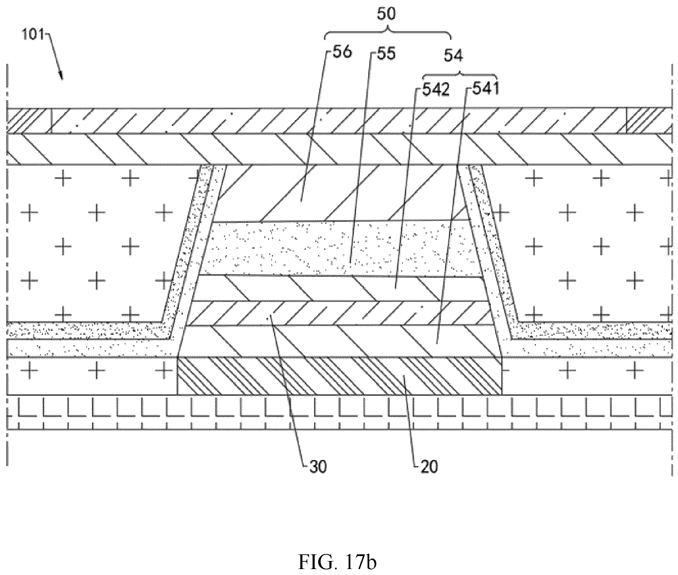

FIG. 17b is a partial sectional view of yet another implementation of the display panel 100 shown in FIG. 2 at A-A.

As shown in FIG. 17b, a first reflection layer 30 may be disposed in a pixel structure 50. For example, the first reflection layer 30 may be disposed in a first semiconductor layer 54 of the pixel structure 50.

For example, the first semiconductor layer 54 may include a first part 541 and a second part 542, and the first reflection layer 30 may be disposed between the first part 541 and the second part 542. The first reflection layer 30 may be configured to electrically connect the first part 541 and the second part 542.

In another implementation, the first reflection layer 30 may be connected between the first semiconductor layer 54 and a first electrode 20. Alternatively, the first reflection layer 30 may be connected between a light emitting layer 55 and the first semiconductor layer 54. It may be understood that the first reflection layer 30 may be disposed on a side that is of the light emitting layer 55 of the pixel structure 50 and that is close to a driver substrate 10. In this way, a first reflection grating 80 and the first reflection layer 30 may form a resonant cavity, to enable light with a specific wavelength emitted by the light emitting layer 55 to resonant.

The first reflection layer 30 may be a multi-periodic DBR that is alternately formed by a plurality of epitaxial materials having different refractive indexes. In some implementations, the first reflection layer 30 may include at least one first reflection unit (not shown in the figure). The first reflection unit may include a first reflection sub-layer and a second reflection sub-layer that are stacked. The first reflection sub-layer in the first reflection unit may be located on a side that is of the second reflection sub-layer and that is close to the driver substrate 10. A material of the first reflection sub-layer of the first reflection unit and a material of the second reflection sub-layer of the first reflection unit may be different.

Both the material of the first reflection sub-layer of the first reflection unit and the material of the second reflection sub-layer may be epitaxial materials. In some implementations, one of the materials of the first reflection sub-layer and the second reflection sub-layer of the first reflection unit may be aluminum gallium nitride (Al-GaN), and the other may be gallium nitride (GaN). For example, the material of the first reflection sub-layer of the first reflection unit may be aluminum gallium nitride (AlGaN), and the material of the second reflection sub-layer of the first reflection unit may be gallium nitride (GaN).

The first reflection layer 30 may include one first reflection unit, or may include a plurality of first reflection units. Specifically, a quantity of first reflection units included in the first reflection layer 30 may be designed based on a requirement. In some implementations, the quantity of first reflection units included in the first reflection layer 30 may be within a range of 1 to 100. For example, the quantity of reflection units included in the first reflection layer 30 may be 1, 10, 30, or 100.

It may be understood that, the materials and corresponding thicknesses of the first reflection sub-layer and the second reflection sub-layer of the first reflection unit may be designed based on a wavelength of a light ray that needs to be reflected, to reflect a target light ray with a specific wavelength. In some implementations, the wavelength of the target light ray that needs to be reflected by the first reflection layer 30 is A, a refractive index of the first reflection sub-layer of the first reflection unit is F, and a refractive index of the second reflection sub-layer of the first reflection unit is G.

The thickness of the first reflection sub-layer of the first reflection unit may be:

$$\frac{1}{4} \times \frac{A}{F} \pm 20 \text{ (nm)}.$$

The thickness of the second reflection sub-layer of the first reflection unit may be:

$$\frac{1}{4} \times \frac{A}{G} \pm 20 \text{ (nm)}.$$

In some implementations, the first reflection layer 30 may be formed through in-situ growth in a process of epitaxial growth of a material wafer of the pixel structure 50.

It may be understood that, a material of the first reflection layer 30 may correspond to a material doping type of the first semiconductor layer 54, and n-type or p-type doping is performed, to implement conductivity.

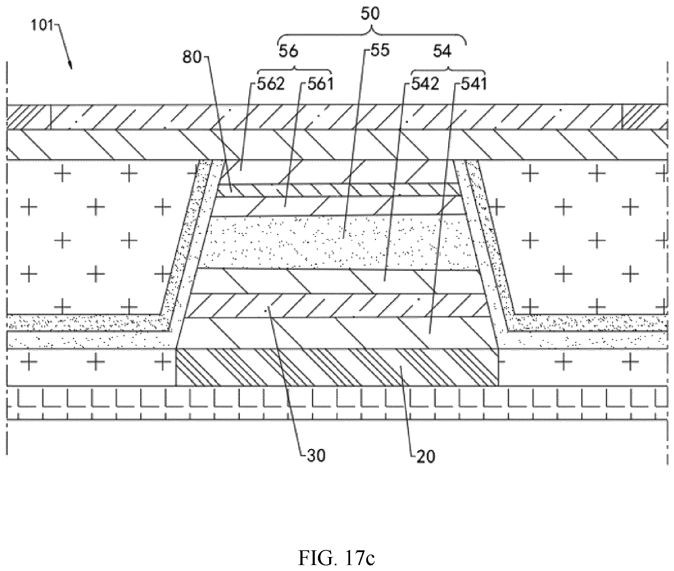

FIG. 17c is a partial sectional view of yet another implementation of the display panel 100 shown in FIG. 2 at A-A.

As shown in FIG. 17c, both a first reflection layer 30 and a first reflection grating 80 may be disposed in a pixel structure 50. For example, a first semiconductor layer 54 may include a first part 541 and a second part 542, and the first reflection layer 30 may be disposed between the first part 541 and the second part 542. The first reflection layer 30 may be configured to electrically connect the first part 541 and the second part 542. A second semiconductor layer 56 may include a first part 561 and a second part 562, the first reflection grating 80 may be disposed between the first part 561 of the second semiconductor layer 56 and the second part 562 of the second semiconductor layer 56, and the first reflection grating 80 may be configured to electrically connect the first part 561 of the second semiconductor layer 56 and the second part 562 of the second semiconductor layer 56.

It may be understood that the first reflection layer 30 may be disposed on a side that is of a light emitting layer 55 and that is close to a driver substrate 10. The first reflection grating 80 may be disposed on a side that is of the light emitting layer 55 and that is away from the driver substrate 10. In this way, the light emitting layer 55 may be located between the first reflection layer 30 and the first reflection grating 80, the first reflection layer 30 and the first reflection grating 80 form a resonant cavity, and the resonant cavity may be configured to enable light with a specific wavelength emitted by the light emitting layer 55 to resonate.

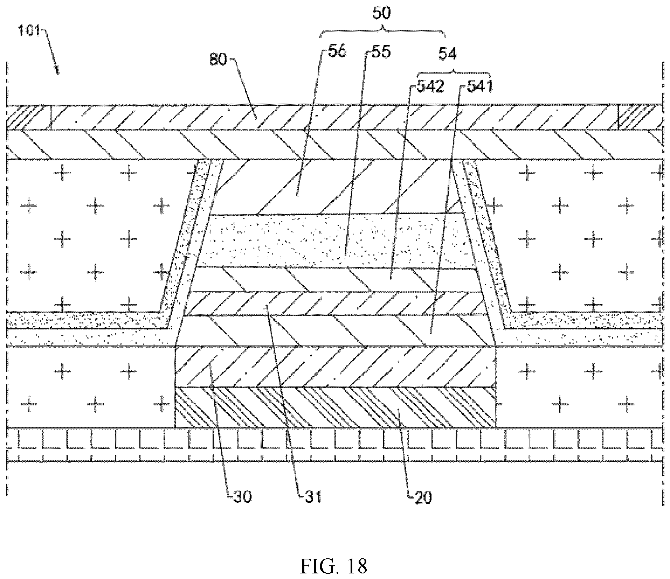

FIG. 18 is a partial sectional view of yet another implementation of the display panel 100 shown in FIG. 2 at A-A.

As shown in FIG. 18, the display panel 100 may further include a second reflection grating 31, in other words, the display panel 100 may include a first reflection layer 30 and the second reflection grating 31. The first reflection layer 30 may be located on a side that is of a first electrode 20 and that is away from a driver substrate 10. A pixel structure 50 may be disposed on a side that is of the first reflection layer 30 and that is away from the driver substrate 10. The second reflection grating 31 may be disposed between the first reflection layer 30 and a light emitting layer 55 of the pixel structure 50. The second reflection grating 31 may be disposed in a semiconductor layer of the pixel structure 50.

For example, a first semiconductor layer 54 may include a first part 541 and a second part 542, and the second reflection grating 31 may be disposed between the first part 541 and the second part 542. The second reflection grating 31 may be configured to electrically connect the first part 541 and the second part 542. The first reflection layer 30 may be a metal layer or a metal-laminated layer. The second reflection grating 31 may be a multi-periodic DBR that is alternately formed by a plurality of epitaxial materials having different refractive indexes.

In some implementations, the second reflection grating 31 may include at least one second grating unit (not shown in the figure), and the second grating unit may include a first reflection sub-grating and a second reflection sub-grating that are stacked. The first reflection sub-grating may be located on a side that is of the second reflection sub-grating and that is close to the driver substrate 10.

Both a material of the first reflection sub-grating of the second grating unit and a material of the second reflection sub-grating are epitaxial materials, and the material of the first reflection sub-grating of the second grating unit and the material of the second reflection sub-grating are different. For example, the material of the first reflection sub-grating of the second grating unit may be aluminum gallium nitride (AlGaN), and the material of the second reflection sub-grating of the second grating unit may be gallium nitride (GaN).

The material of the first reflection sub-grating of the second grating unit and the material of the second reflection sub-grating may have different refractive indexes.

In some implementations, the refractive index of the first reflection sub-grating of the second grating unit is within a range of 1 to 5. The refractive index of the second reflection sub-grating of the second grating unit is within the range of 1 to 5.

In some implementations, a difference between the refractive index of the first reflection sub-grating of the second grating unit and the refractive index of the second reflection sub-grating is N, and N meets: $N \geq 0.2$. In another implementation, N may be less than 0.2.

It may be understood that, in the second grating unit, the refractive index of the first reflection sub-grating may be greater than the refractive index of the second reflection sub-grating, or the refractive index of the first reflection sub-grating may be less than the refractive index of the second reflection sub-grating. A larger difference M between the refractive index of the first reflection sub-grating and the refractive index of the second reflection sub-grating indicates a better reflection effect of the second reflection grating 31 on a target light ray.

In some implementations, the second reflection grating 31 may be formed through in-situ growth in a process of epitaxial growth of a material wafer of the pixel structure 50.

It may be understood that, a material of the second reflection grating 31 may correspond to a material doping type of the first semiconductor layer 54, and n-type or p-type doping is performed, to implement conductivity.

It may be understood that, compared with a solution in which a display panel 100 has only a first reflection layer 30 or a second reflection grating 31, in this solution, the display panel 100 includes the first reflection layer 30 and the second reflection grating 31, and the first reflection layer 30 and the second reflection grating 31 may form a resonant cavity with a first reflection grating 80, so that a light ray in a direction of the first reflection grating 80 toward the driver substrate 10 in the display panel 100 can be reflected as much as possible, thereby improving light emitting efficiency of the display panel 100. A person skilled in the art may selectively set the display panel 100 to include the first reflection layer 30 or the second reflection grating 31 or set the display panel 100 to include the first reflection layer 30 and the second reflection grating 31 based on a requirement.

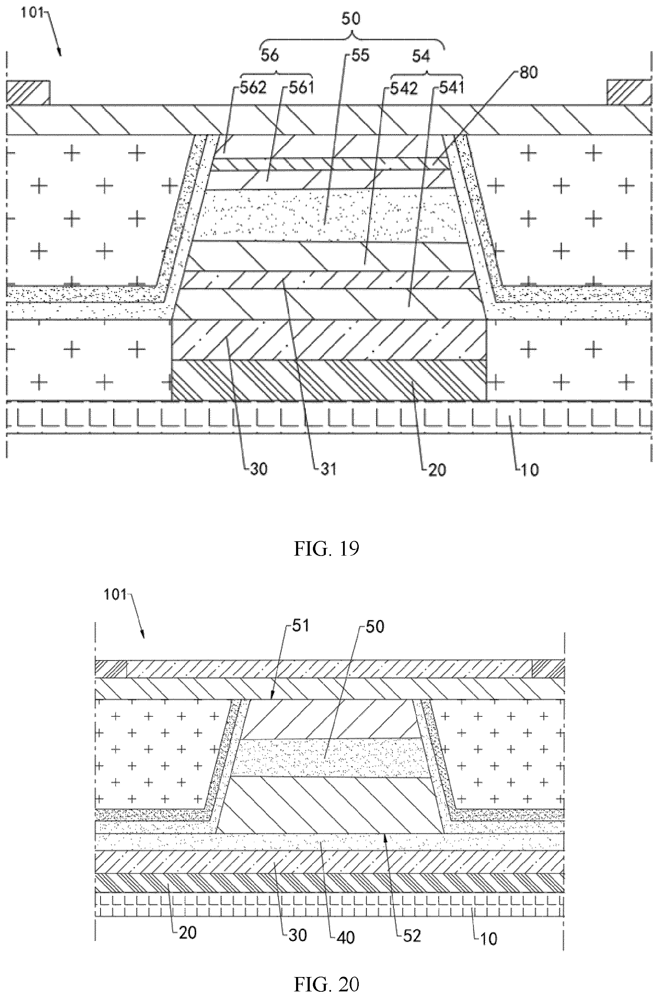

FIG. 19 is a partial sectional view of yet another implementation of the display panel 100 shown in FIG. 2 at A-A.

As shown in FIG. 19, a first reflection grating 80 may be disposed on a side that is of a light emitting layer 55 of a pixel structure 50 and that is away from a driver substrate 10, and a second conductive layer 70 may be disposed on a side that is of the first reflection grating 80 and that is away from the driver substrate 10. The display panel 100 may include a first reflection layer 30 and a second reflection grating 31. The first reflection layer 30 may be located on a side that is of a first electrode 20 and that is away from the driver substrate 10. The pixel structure 50 may be disposed on a side that is of the first reflection layer 30 and that is away from the driver substrate 10. The second reflection grating 31 may be disposed between the light emitting layer 55 of the pixel structure 50 and the first reflection layer 30.

It may be understood that a person skilled in the art may selectively set positions of the first reflection grating 80, the first reflection layer 30, and the second reflection grating 31 based on a requirement.

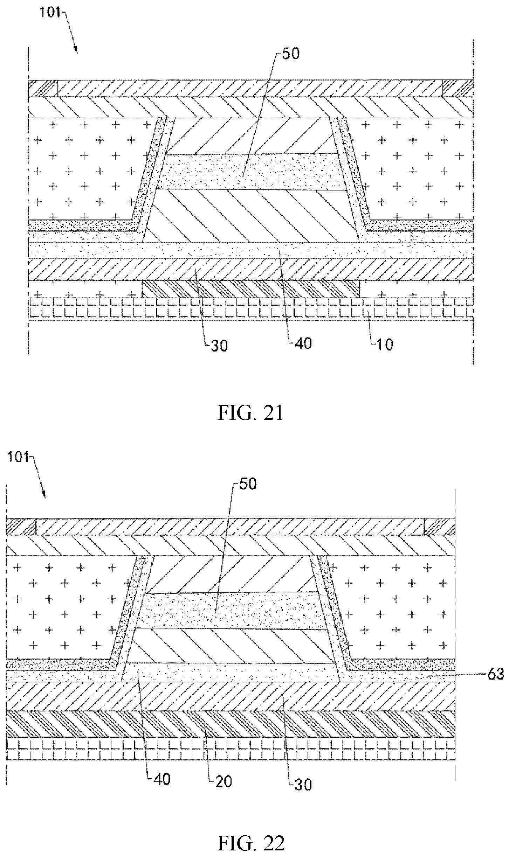

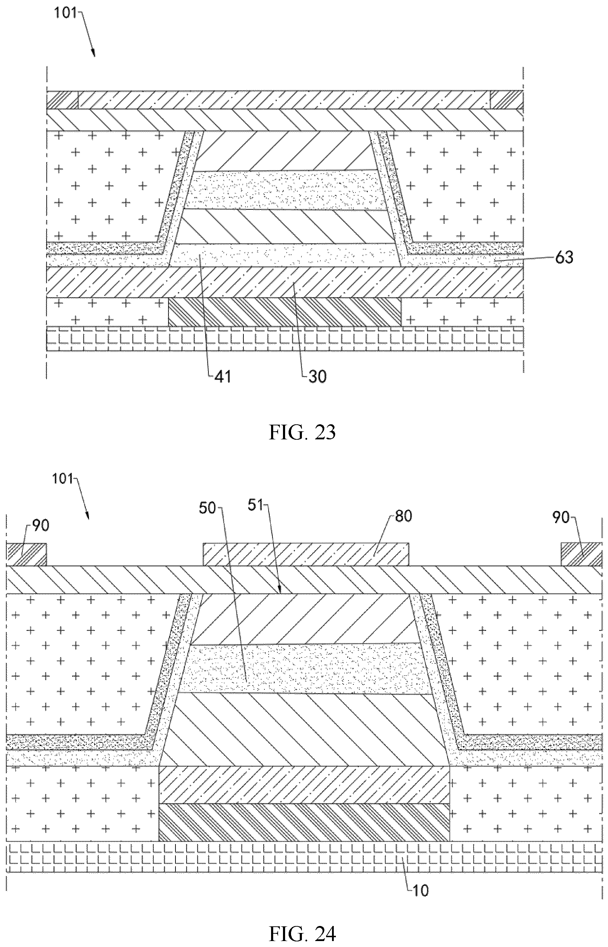

In some implementations, technical content that is the same as that of the display panel 100 (as shown in FIG. 3) in the foregoing implementations is not described again. FIG. 20 is a partial sectional view of yet another implementation of the display panel 100 shown in FIG. 2 at A-A. FIG. 21 is a partial sectional view of yet another implementation of the display panel 100 shown in FIG. 2 at A-A. FIG. 22 is a partial sectional view of yet another implementation of the display panel 100 shown in FIG. 2 at A-A. FIG. 23 is a partial sectional view of yet another implementation of the display panel 100 shown in FIG. 2 at A-A.

As shown in FIG. 20 to FIG. 23, a first reflection layer 30 may be disposed in a tiling manner at an entire layer, and the first reflection layer 30 may be connected to a plurality of pixel structures 50. In some implementations, the first reflection layer 30 may be connected to all pixel structures 50 on the display panel 100. The first reflection layer 30 may be disposed on a side that is of a first electrode 20 and that is away from a driver substrate 10, and a first conductive layer 40 may be disposed on a side that is of the first reflection layer 30 and that is away from the driver substrate 10.

It may be understood that, in a preparation process of the first reflection layer 30 disposed in the tiling manner at the entire layer, after a deposition process, an etching process may be omitted, thereby helping reduce costs. The first reflection layer 30 disposed in the tiling manner at the entire layer may reflect, as much as possible, a light ray emitted by the pixel structure 50 from a bottom surface 52, so that the reflected light ray is emitted from a top surface 51 of the pixel structure 50 as much as possible, that is, light emitting intensity in a forward direction of the display panel 100 can be improved.

As shown in FIG. 20 and FIG. 21, the first conductive layer 40 may also be disposed in the tiling manner at an entire layer. The first conductive layer 40 may be connected to a plurality of pixel structures 50. In some implementations, the first conductive layer 40 may be connected to all pixel structures 50 on the display panel 100. The first conductive layer 40 may be disposed on a side that is of the first reflection layer 30 and that is away from the driver substrate 10. In this way, the pixel structure 50 on the display panel 100 may be turned on or turned off.

It may be understood that the first conductive layer 40 is disposed in the tiling manner at the entire layer, and the step of etching the to-be-processed first conductive layer 108 to form the plurality of first conductive layers 40 spaced apart in the foregoing step 5 may be omitted. This helps simplify a process and accelerate a preparation process.

As shown in FIG. 20 and FIG. 22, the first electrode 20 may also be disposed in the tiling manner at an entire layer. The first electrode 20 may be connected to a plurality of pixel structures 50. In some implementations, the first electrode 20 may be connected to all pixel structures 50 on the display panel 100.

In this way, all pixel structures 50 on the display panel 100 may be turned on or turned off. It may be understood that the first electrode 20 is disposed in the tiling manner at the entire layer, and the preparation step of forming a plurality of first electrodes 20 spaced apart in the foregoing step 1 may be omitted. This helps simplify a process and accelerate a preparation process.

As shown in FIG. 22 and FIG. 23, there may be a plurality of first conductive layers 40, and a quantity of first conductive layers 40 and a quantity of pixel structures 50 may be set in one-to-one correspondence. In this case, a passivation layer 63 may be connected to the pixel structure 50, the first conductive layer 40, and the first reflection layer 30. The passivation layer 63 may be further configured to insulate adjacent first conductive layers 40.

It may be understood that shapes of the first reflection layer 30, the first conductive layer 40, and the first electrode 20 may change based on an actual requirement. This is not limited in this application.

In some implementations, technical content that is the same as that of the display panel 100 (as shown in FIG. 3) in the foregoing implementations is not described again. FIG. 24 is a partial sectional view of yet another implementation of the display panel 100 shown in FIG. 2 at A-A.

As shown in FIG. 24, in some implementations, the display panel 100 may include a plurality of first reflection gratings 80, and the plurality of first reflection gratings 80 may be spaced apart. The plurality of first reflection gratings 80 may be disposed opposite to a plurality of pixel structures 50 in one-to-one correspondence. To be specific, a quantity of first reflection gratings 80 may be equal to a quantity of pixel structures 50, and the first reflection grating 80 may be disposed opposite to the pixel structure 50 corresponding to the first reflection grating 80.

In some implementations, in a direction perpendicular to a driver substrate 10, projection of the first reflection grating 80 on the driver substrate 10 and projection of a top surface 51 of the pixel structure 50 on the driver substrate 10 may overlap.

It may be understood that, compared with the foregoing solution in which the first reflection grating 80 is disposed in the tiling manner at the entire layer, in this solution, when the display panel 100 displays a frame of picture, if one of two adjacent pixel structures 50 emits light and the other does not emit light, one pixel structure 50 corresponds to one first reflection grating 80, the first reflection gratings 80 are spaced apart, and crosstalk of a light ray of the pixel structure 50 that emits light to the pixel structure 50 that does not emit light does not easily occur by using the first reflection grating 80, so that a display effect of the display panel 100 is good.

In some implementations, the first reflection grating 80 may be disposed at an interval from a second electrode 90, and a dielectric material may be filled between the first reflection grating 80 and the second electrode 90.

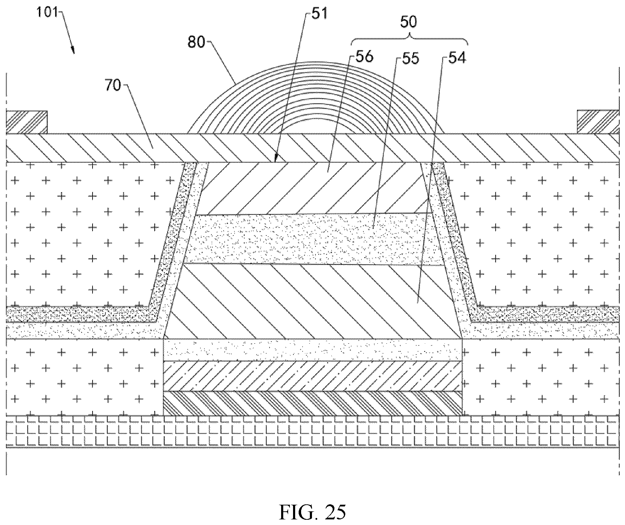

In some implementations, technical content that is the same as that of the display panel 100 (as shown in FIG. 3) in the foregoing implementations is not described again. FIG. 25 is a partial sectional view of yet another implementation of the display panel 100 shown in FIG. 2 at A-A.

As shown in FIG. 25, a first reflection grating 80 may be arc-shaped. The first reflection grating 80 may have a curved surface.

It may be understood that the first reflection grating 80 may reflect light in a normal direction emitted from a top surface 51 of a pixel structure 50, and the reflected light can still be in the normal direction, and can be reflected by a first reflection layer 30 again, to form resonance. Light that deviates from the normal direction is converged to the normal direction by the curved surface within a specific range, to increase a proportion of light in the normal direction, so that resonance enhancement can be performed on more light rays in a resonant cavity, and light emitting efficiency of the display panel 100 can be improved.

In this application, several structures of the display panel 100 are specifically described with reference to related accompanying drawings. It may be understood that the display area 101 of the display panel 100 provided in this application includes the driver substrate 10, the pixel structure 50, the first reflection layer 30, the first reflection grating 80, and the second reflection layer 64. The driver substrate 10, the first reflection layer 30, and the pixel structure 50 are sequentially disposed. The first reflection layer 30 and the first reflection grating 80 may form the resonant cavity. The resonant cavity may enable light (namely, a target light ray) with a specific wavelength emitted by the pixel structure 50 to resonate back and forth between the first reflection layer 30 and the first reflection grating 80, so that the target light ray can generate resonance enhancement, to enhance light emitted in the normal direction of the display panel 100.

A vertical cavity length L of the resonant cavity, and thicknesses and materials of the first reflection grating 80 and the first reflection layer 30 may be selected based on the wavelength of the target light ray, so that the formed resonant cavity performs resonance enhancement for the target light ray with a specific wavelength. A light ray with another wavelength is not enhanced, and the first reflection grating 80 causes partial blocking. The enhanced target light ray is finally emitted from the display panel 100, and is received by a user, so that the resonant cavity can improve light emitting efficiency of the display panel 100 and reduce a half width of a light emitting spectrum of the light ray emitted by the pixel structure 50.

The resonant cavity formed by the first reflection layer 30 and the first reflection grating 80 may generate resonance for a light ray in a direction perpendicular to a light emitting surface of the display panel 100 and a nearby light ray. Therefore, the resonant cavity enhances light emitted in the normal direction, and a light ray with a large deviation angle from the normal direction is weakened. Therefore, the resonant cavity may further play a role of regulating and reducing light emitting angle distribution of the display panel 100.

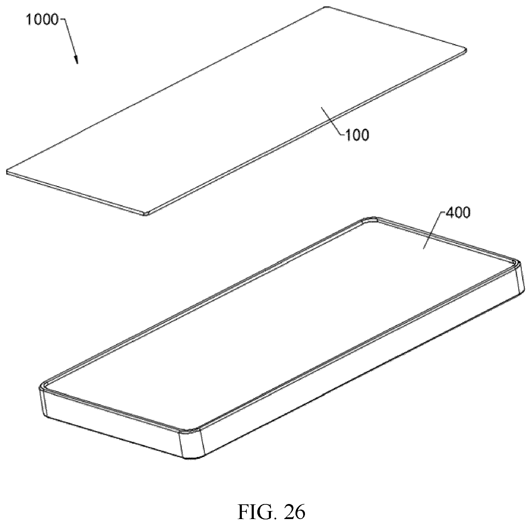

The second reflection layer 64 is connected to a side surface 53 of the pixel structure 50, and can reflect a light ray emitted by the pixel structure 50 from the side surface 53, to avoid a problem of optical crosstalk between two adjacent pixel structures 50. To be specific, a light ray emitted by one of the pixel structures 50 from a side surface 53 is not easily propagated to the other pixel structure 50. Particularly, when the display panel 100 displays a frame of picture, if one of the two adjacent pixel structures 50 needs to emit light and the other does not emit light, crosstalk of a light ray of the pixel structure 50 that emits light to the pixel structure 50 that does not emit light does not easily occur. The second reflection layer 64 reflects the light ray emitted by the pixel structure 50 from the side surface 53, so that most of the light ray emitted by the pixel structure 50 from the side surface 53 can be reflected back to the pixel structure 50 by the second reflection layer 64, and then is emitted from the top surface 51 of the pixel structure 50 and received by the user, to improve light emitting intensity of a front surface of the display panel 100. FIG. 26 is a diagram of a structure of an implementation of an electronic device 1000 according to an embodiment of this application.

This application provides an electronic device 1000. Alternatively, the electronic device 1000 may be a device having a display panel 100, for example, a mobile phone, a tablet computer (tablet computer), a laptop computer (laptop computer), a personal digital assistant (personal digital assistant, PDA), a notebook computer, or a vehicle-mounted device. An example in which the electronic device 1000 in the embodiment shown in FIG. 26 is the mobile phone is used as an example for description.

As shown in FIG. 26, the electronic device 1000 includes the display panel 100 and a bearing member 400. For a structure of the display panel 100, refer to the structure of the display panel 100 in the foregoing embodiment. The display panel 100 is configured to display an image. The bearing member 400 may be used as a structural bearing member of the display panel 100. When the electronic device 1000 is a mobile phone, the bearing member 400 may be a housing of the mobile phone. It may be understood that a specific form and structure of the bearing member 400 may change based on an actual situation, so that the bearing member 400 can be configured to carry the display panel 100. This is not specifically limited in this application.

It should be noted that embodiments in this application and features in embodiments may be combined with each other without a conflict, and any combination of features in different embodiments also falls within the protection scope of this application. In other words, the foregoing described plurality of embodiments may further be combined based on an actual requirement.

It should be noted that all the foregoing accompanying drawings are examples of this application, and do not represent actual sizes of products. In addition, a size proportion relationship between components in the accompanying drawings is not intended to limit an actual product in this application.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1. A display panel, wherein the display panel comprises a display area, and the display area comprises a driver substrate, a pixel structure, a first reflection layer, a first reflection grating, and a second reflection layer;

   the driver substrate, the first reflection layer, and the pixel structure are sequentially disposed, the driver substrate is configured to enable the pixel structure to emit light, and the second reflection layer is connected to a side surface of the pixel structure; and
   the first reflection grating and the first reflection layer form a resonant cavity, and the resonant cavity is configured to enable light with a specific wavelength emitted by the pixel structure to resonate.

2. The display panel according to claim 1, wherein the first reflection grating is disposed on a side that is of the pixel structure and that is away from the first reflection layer.

3. The display panel according to claim 1, wherein the pixel structure comprises a first semiconductor layer, a light emitting layer, and a second semiconductor layer, the light emitting layer is located between the first semiconductor layer and the second semiconductor layer, the resonant cavity is configured to enable light with a specific wavelength emitted by the light emitting layer to resonate, the first reflection layer is disposed between the driver substrate and the first semiconductor layer, the first reflection grating is disposed in the second semiconductor layer, and the second reflection layer is connected to a side surface of the light emitting layer.

4. The display panel according to any one of claims 1 to 3, wherein in a direction of the first reflection layer toward the first reflection grating, a vertical cavity length of the resonant cavity is within a range of 0.5 micrometers to 4 micrometers.

5. The display panel according to any one of claims 1 to 4, wherein the first reflection grating is a Distributed Bragg Reflector, the first reflection grating comprises at least one first grating unit, and the first grating unit comprises a first reflection sub-grating and a second reflection sub-grating that are stacked;

   a refractive index of the first reflection sub-grating of the first grating unit is within a range of 1 to 5;
   a refractive index of the second reflection sub-grating of the first grating unit is within the range of 1 to 5; and
   a difference between the refractive index of the first reflection sub-grating of the first grating unit and the refractive index of the second reflection sub-grating of the first grating unit is M, and M meets: M≥0.2.

6. The display panel according to any one of claims 1 to 5, wherein the display panel further comprises a first conductive layer, and the first conductive layer is connected between the first reflection layer and the pixel structure.

7. The display panel according to any one of claims 1 to 6, wherein the display panel further comprises a second conductive layer, and the second conductive layer is connected between the first reflection grating and the pixel structure.

8. The display panel according to any one of claims 1 to 7, wherein the display panel further comprises a passivation layer, the passivation layer is connected between the side surface of the pixel structure and the second reflection layer, and the passivation layer is configured to insulate the pixel structure from the second reflection layer.

9. The display panel according to any one of claims 1 to 8, wherein the first reflection grating is arc-shaped.

10. The display panel according to any one of claims 1 to 9, wherein the first reflection layer is a Distributed Bragg Reflector, the first reflection layer comprises at least one first reflection unit, the first reflection unit comprises a first reflection sub-layer and a second reflection sub-layer that are stacked, a material of the first reflection sub-layer is silicon dioxide, and a material of the second reflection sub-layer is titanium dioxide.

11. The display panel according to claim 10, wherein the first reflection layer is provided with a first through hole, the display panel further comprises a first electrode, the first electrode is disposed in the first through hole, one end of the first electrode is electrically connected to the driver substrate, and the other end is electrically connected to the pixel structure.

12. The display panel according to any one of claims 1 to 9, wherein the display panel further comprises a second reflection grating, and the second reflection grating is located in the semiconductor layer of the pixel structure.

13. The display panel according to any one of claims 1 to 12, wherein a height of the pixel structure in a thickness direction of the display panel is within a range of 100 nanometers to 10 micrometers; and
a width of the pixel structure in a direction parallel to the display panel is within a range of 100 nanometers to 1 millimeter.

14. The display panel according to any one of claims 1 to 13, wherein a light emitting angle of the display panel is less than 40°.

15. The display panel according to any one of claims 1 to **14,** wherein a spectral half-peak width of a light ray emitted by the display panel is within a range of 5 nanometers to 100 nanometers.

16. An electronic device, comprising a bearing member and the display panel according to any one of claims 1 to 15, wherein the bearing member is configured to bear the display panel.

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13

FIG. 14

FIG. 15

FIG. 16

FIG. 17a

FIG. 17b

FIG. 17c

FIG. 18

FIG. 19

FIG. 20

FIG. 21

FIG. 22

FIG. 23

FIG. 24

FIG. 25

FIG. 26

| INTERNATIONAL SEARCH REPORT | International application No. |
|---|---|
| | **PCT/CN2024/072270** |

**A.    CLASSIFICATION OF SUBJECT MATTER**

H01L27/15(2006.01)i

According to International Patent Classification (IPC) or to both national classification and IPC

**B.    FIELDS SEARCHED**

Minimum documentation searched (classification system followed by classification symbols)

IPC: H01L,H10K

Documentation searched other than minimum documentation to the extent that such documents are included in the fields searched

Electronic data base consulted during the international search (name of data base and, where practicable, search terms used)

CNABS; CNTXT; CNKI; VEN; ENTXT; IEEE: 侧, 反射, 光栅, 微发光二极管, 微型发光二极管, 显示, 谐振, 增强, display, micro, reflect+, resonat+, LED?

**C.    DOCUMENTS CONSIDERED TO BE RELEVANT**

| Category* | Citation of document, with indication, where appropriate, of the relevant passages | Relevant to claim No. |
|---|---|---|
| Y | CN 112951866 A (SAMSUNG ELECTRONICS CO., LTD.) 11 June 2021 (2021-06-11) description, paragraphs [0061]-[0161], and figures 1-29 | 1-16 |
| Y | CN 114122223 A (SHARP FUKUYAMA SEMICONDUCTOR CO., LTD.) 01 March 2022 (2022-03-01) description, paragraphs [0011]-[0120], and figures 1-17 | 1-16 |
| A | WO 2012108384 A1 (SHARP K. K.) 16 August 2012 (2012-08-16) entire document | 1-16 |
| A | JP 2017004639 A (SHARP K. K.) 05 January 2017 (2017-01-05) entire document | 1-16 |

☐ Further documents are listed in the continuation of Box C.      ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **13 March 2024** | **20 March 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2024/072270**

| Patent document cited in search report | | | Publication date (day/month/year) | Patent family member(s) | | | Publication date (day/month/year) |
|---|---|---|---|---|---|---|---|
| CN | 112951866 | A | 11 June 2021 | KR | 20210073955 | A | 21 June 2021 |
| | | | | US | 2021183301 | A1 | 17 June 2021 |
| | | | | US | 11430374 | B2 | 30 August 2022 |
| | | | | US | 2022246092 | A1 | 04 August 2022 |
| | | | | US | 11837155 | B2 | 05 December 2023 |
| | | | | US | 2023395016 | A1 | 07 December 2023 |
| | | | | EP | 3836212 | A1 | 16 June 2021 |
| | | | | EP | 3836212 | B1 | 26 April 2023 |
| CN | 114122223 | A | 01 March 2022 | JP | 2022037718 | A | 09 March 2022 |
| | | | | US | 2022069182 | A1 | 03 March 2022 |
| WO | 2012108384 | A1 | 16 August 2012 | TW | 201240183 | A | 01 October 2012 |
| JP | 2017004639 | A | 05 January 2017 | | None | | |

Form PCT/ISA/210 (patent family annex) (July 2022)

## EP 4 557 374 A1

**REFERENCES CITED IN THE DESCRIPTION**

**Patent documents cited in the description**

- CN 202310090546X